# EUROPEAN PATENT SPECIFICATION

(11) **EP 1 143 301 B1**
(45) Date of publication and mention of the grant of the patent: **11.11.2009**
(21) Application number: 01107752.6
(22) Date of filing: 03.04.2001
(51) Int. Cl.: G03F 7/095, B41N 1/08

(54) **Presensitized plate useful for preparing a lithographic printing plate**
Vorsensibilisierte Platte zur Herstellung einer lithographischen Druckplatte
Plaque présensibilisée pour la fabrication d'une plaque d'impression lithographique

(30) Priority: 05.04.2000 JP 2000103135
(43) Date of publication of application: 10.10.2001
(73) Proprietor: FUJIFILM Corporation, Minato-ku Tokyo (JP)
(72) Inventor: Shiraishi, Yuichi, Fuji Photo Film Co. Ltd, Haibara-gun, Shizuoka-ken (JP)
(74) Representative: HOFFMANN EITLE

(56) References cited:
- US-A- 4 845 009
- US-A- 5 232 813
- US-A- 5 272 035
- DATABASE WPI Section Ch, Week 199246 Derwent Publications Ltd., London, GB; Class A89, AN 1992-375889 XP002171808 & JP 04 274429 A (FUJI PHOTO FILM CO LTD), 30 September 1992 (1992-09-30)

## Description

### BACKGROUND OF THE INVENTION

The present invention relates to a presensitized plate useful for preparing a lithographic printing plate and more specifically, a presensitized plate comprising a photosensitive layer comprised of photocrosslinking composition, useful for preparing a lithographic printing plate having an improved sensitivity and printing durability.

There have been well-known photocrosslinkable materials capable of causing crosslinking through a cyclization reaction and these materials have widely been employed as a principal ingredient of a photosensitive composition for preparing presensitized plates or the like. As such photocrosslinkable materials, a photosensitive composition comprising a polymer carrying maleimido group on the side chain and a sensitizer have been reported, for example, in J.P. KOKAI No. Hei 6-107718, J.P. KOKAI No. Hei 7-295212, and J.P. KOKAI No. Hei 8-254825.

However, use of the photocrosslinkable photosensitive composition alone does not provide sufficient adhesion to hydrophilized surface of substrate and results in low durability of the image area. Therefore, some attempts have been made to improve the adhesion of photosensitive layer to the substrate. One of the methods to solve the problem is to add a diazo resin to the photosensitive layer as disclosed in Japanese Patent Publication for Opposition Purpose (hereinafter referred to as "J.P.KOKOKU") No Hei 5-2227, Japanese Unexamined Patent Publication (hereinafter referred to as "J.P. KOKAI") No. Hei 3-2868, J.P. KOKAI No. Hei 3-240061, and J.P. KOKAI No. Hei 4-274429. However, still the printing durability of the photosensitive layer is not sufficient. In order to eliminate this problem, J.P. KOKAI No. Hei 4-274429 discloses a method in which an intermediate layer comprising diazo resin is formed between the substrate and the photosensitive layer. But the effect of this method is still insufficient.

### SUMMARY OF THE INVENTION

It is an object of the present invention to provide a presensitized plate useful for preparing a lithographic printing plate which shows good printing durability while maintaining excellent properties required for lithographic printing plate such as sensitivity and easiness to see print-out image after exposure and after development.

The inventors of this invention have conducted intensive studies to solve the foregoing problems associated with the conventional techniques, and have found out that the foregoing objects of the present invention can effectively be achieved by forming a layer having a polyurethane resin having acidic hydrogen atom and a diazo resin between substrate and photosensitive layer of photocrosslinking composition.

The present invention consequently relates to a presensitized plate useful for preparing a lithographic printing plate comprising layer (A) coated on an aluminum substrate having a hydrophilized surface, and layer (B) coated on said layer (A), wherein layer (A) comprises at least one polyurethane resin having an acidic hydrogen atom and at least one diazo resin and layer (B) comprises at least one sensitizer and at least one polymer which is soluble or swellable in an alkaline water and which has at least two groups represented by the following general formula (A) on the side chain. 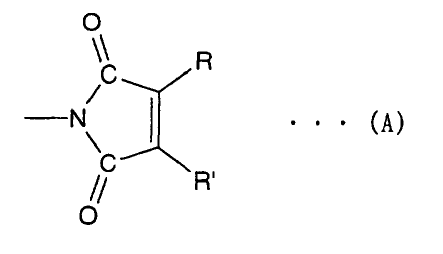 wherein, R and R' independently represents hydrogen atom, halogen atom, or alkyl group, or R and R' may be linked together to form a 5- or 6-membered:

The present invention is **characterized in that** layer (A) prepared from photosensitive composition comprising polyurethane resin and diazo resin plays a role of adhesive layer, which results in superior to the conventional intermediate layer comprising only diazo resin.

### DESCRIPTION OF THE PREFERRED EMBODIMENTS

The presensitized plate of the present invention will be hereinafter described in more detail.

The presensitized plate of the present invention can be prepared by a variety of methods, but generally prepared by applying a composition comprising at least one polyurethane resin having at least one acidic hydrogen atom and at least one diazo resin on a substrate of which surface have been hydrophilized to form layer (A) followed by applying a composition comprising at least one sensitizer and at least one polymer which is soluble or swellable in an alkaline water and which has at least two groups represented by general formula (A) on the side chain to form layer (B) on layer (A).

The total thickness of layer (A) and layer (B) may range generally from 0.2 to 10 g/m² and preferably from 0.3 to 5 g/m². If the total thickness is less than 0.2 g/m², printing durability of the plate will be lowered. If the total thickness is more than 10 g/m², photocrosslinking reaction during imagewise exposure of the plate will not easily proceed since the light for exposure does not completely reach into the layer.

In the present invention, within the above-described total thickness of layers (A) and (B), the thickness of layer (B) ranges equal to that of layer (A) to 500 times as thick as that of layer (A) and preferably 1.5 times to 100 times as thick as that of layer (A). It is desired that the thicknesses of layer (B) and layer (A) satisfy the total thickness and the ratio of thickness defined above. Particularly, if layer (A) is out of the desired range, it can not sufficiently play a role as the adhesive layer.

### [Layer (A)]

Layer (A) of the presensitized plate of the present invention can be formed by dissolving or suspending a photosensitive composition comprising at least one polyurethane having at least one acidic hydrogen atom and at least one diazo resin as essential components and other optional components in a proper solvent and then applying the resulting coating solution onto an aluminum substrate which has been subjected to hydrophilization treatment described below.

### (Polyurethane resin having acidic hydrogen atom)

In the present invention, "polyurethane resin having at least one acidic hydrogen atom" is a polyurethane resin having at least one group with at least one acidic hydrogen atom on the side chain or main chain. The group with at least one acidic hydrogen atom means a group showing pKa at 7 or below in water. Specific examples of such group include -COOH, -SO₂ NHCOO-, - CONHSO₂-, -CONHSO₂NH-, -NHCONHSO₂-. Particularly preferred group is -COOH. The acid value is preferably from 0.05 to 6 milliequivalent per 1 g of polyurethane resin. If the value is less than 0.05 milliequivalents, developability of the plate in an alkaline developer would not be sufficient. If the acid value is more than 6 milliequivalents, abrasiveness of the plate would not be sufficient. Preferably the acid value ranges from 0.2 to 4 milliequivalents.

The aforementioned polyurethane resin can be prepared by a variety of methods. For example, a polyurethane resin comprising a carboxyl group as the group having acidic hydrogen atom is obtainable by reacting a diisocyanate compound represented by the following general formula (I) with a diol compound containing carboxyl group represented by the following general formula (II), (III) or (IV).

OCN-R¹-NCO (I)

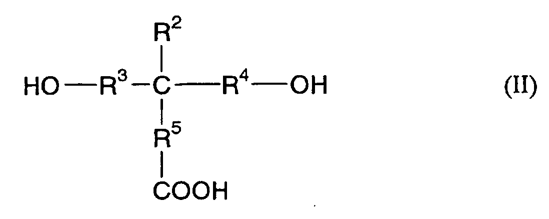

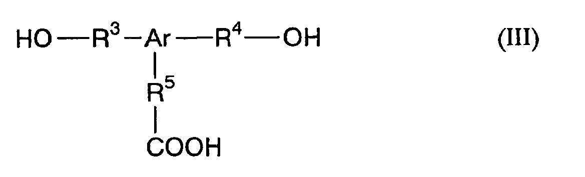

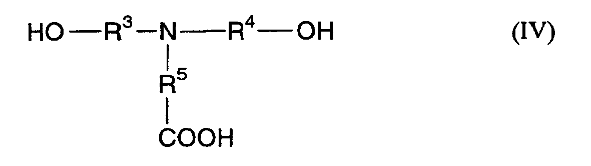

wherein,
R¹ represents bivalent aliphatic or aromatic hydrocarbon and more preferably alkylene or arylene group, each of which is optionally substituted by, for example, alkyl, alkenyl, aralkyl, aryl, alkoxy and/or halogen group. If necessary, R¹ may further comprise other functional group that does not react with isocyanate, such as ester, urethane, amide or ureido group or carbon-carbon unsaturated bond.
R² represents hydrogen atom, alkyl, alkenyl, aralkyl, aryl, alkoxy, or aryloxy group, and preferably hydrogen atom, C1∼C8 alkyl group or C2∼C8 alkenyl group, or C6∼C15 aryl group, each of which excepting hydrogen atom is optionally substituted by, for example, alkyl, aryl, alkoxy, ester, urethane, amide, ureido and/or halogen group.
R³, R⁴ and R⁵ may be the same or different and each represents single bond, bivalent aliphatic or aromatic hydrocarbon, preferably C1 ∼ C20 alkylene group, C6∼C15 arylene group, and more preferably C1∼C8 alkylene group, each of which is optionally substituted by, for example, alkyl, alkenyl, aralkyl, aryl, alkoxy and/or halogen group. If necessary, R³, R⁴ and R⁵ may comprise other functional group that does not react with isocyanate group, such as ester, urethane, amide or ureido group or carbon-carbon unsaturated bond. In addition, two or three of R², R³, R⁴ and R⁵ may be linked together to form a ring.
"Ar" represents trivalent aromatic hydrocarbon and preferably those having 6 to 15 carbon atoms, which is optionally substituted by, for example, alkyl, alkenyl, aralkyl, aryl, alkoxy and/or halogen group.

Examples of diisocyanate compounds represented by general formula (I) include the following compounds;
aromatic diisocyanate compounds such as 2,4-tolylene diisocyanate, 2,4-tolylene diisocyanate dimer, 2,6-tolylene diisocyanate, p-xylylene diisocyanate, m-xylylene diisocyanate, 4,4'-diphenylmethane diisocyanate, 1,5-naphthylene diisocyanate, and 3,3'-dimethylbiphenyl-4,4'-diisocyanate; aliphatic diisocyanate compounds such as hexamethylene diisocyanate, trimethylhexamethylene diisocyanate, lysine diisocyanate, and dimer acid diisocyanate; aliphatic cyclic diisocyanate compounds such as isophorone diisocyanate, 4,4'-methylene bis(cyclohexylisocyanate), methylcyclohexane-2,4( or 2,6)-diisocyanate, and 1,3-(isocyanatemethyl)cyclohexane; reaction product of a diol compound and a diisocyanate compound such as reaction product of 1 mole of 1,3-butylene glycol and 2 moles of tolylene diisocyanate.

Examples of carboxyl group containing a diol compound represented by general formula (II), (III) or (IV) include the following compounds;
3,5-dihydroxybenzoic acid, 2,2-bis(hydroxymethyl)propionic acid, 2,2-bis(2-hydroxyethyl)propionic acid, 2,2-bis(3-hydroxypropyl)propionic acid, bis(hydroxymethyl)acetic acid, bis(4-hydroxyphenyl)acetic acid, 4,4-bis(4-hydroxyphenyl)pentanoic acid, tartaric acid, and N,N-bis(2-hydroxyethyl)-3-carboxy-propionamide.

Example of other polyurethane resin having a group with acidic hydrogen atom other than carboxyl group include a polyurethan resin of which main structure is from a reaction product of a diisocyanate compound represented by general formula (I) with a diol compound represented by general formula (V), (VI), (VII) or (VIII).

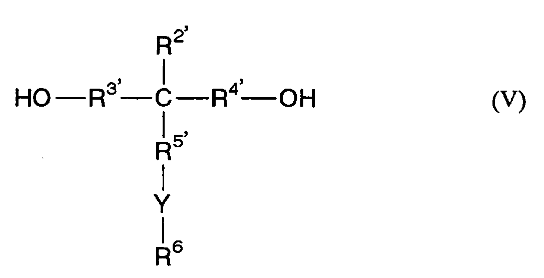

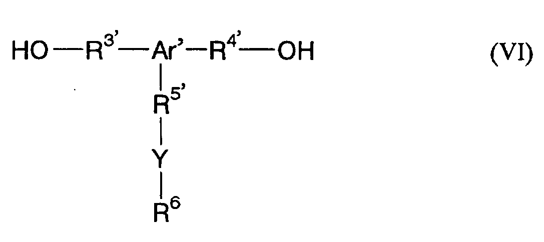

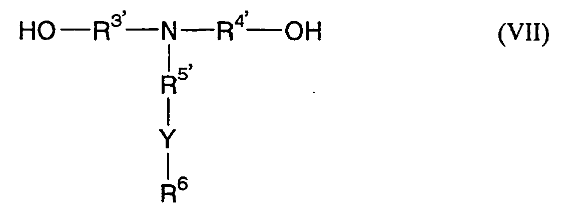

HO-R^{3'}-Y-R^{4'}-OH (VIII)

wherein, the definitions of R^{2'}, R^{3'}, R^{4'}, R^{5'} and Ar' are the same as those of R², R³, R⁴, R⁵ and Ar, respectively. R⁶ represents monovalent aliphatic or aromatic hydrocarbon, preferably from C1∼C20 alkyl group, C2 ∼C20 alkenyl group, C6∼C15 aryl group, or C7∼15 aralkyl group and more preferably, C1∼C8 alkyl group, C2∼C8 alkenyl group, or C6∼C10 aryl group, each of which is optionally substituted by, for example, alkyl, alkoxy and/or halogen atom.
Y represents -sulfonylamide group (-CO-NH-SO₂-), N-sulfonylureido group (-NH-CO-NH-SO₂-), N-aminosulfonylamide group (-CO-NH-SO₂-NH-) or sulfonylurethane group (-O-CO-NH-SO₂-).

The diol compound of general fomula (V), (VI), or (VII) can be prepared by, for example, reacting hydroxy-protected diol compound which has carboxyl group and is represented by general formula (II), (III), or (IV) with the compound of general formula (X), (XI) or (XII) followed by deblocking the hydroxy-protected group.

X-A-CO-NH-SO²-R⁶ (X)

X-A-NH-CO-NH-SO₂-R⁶ (XI)

X-A-CO-NH-SO₂-NH-R⁶ (XII)

wherein, X represents chlorine or bromine atom.

For example, the compound of general formula (X) can be prepared by reacting the compounds of general formulas (XIV) and (XV), the compound of general formula (XI) cen be prepared by reacting the compounds of general formulas (XVI) and (XV), and the compound of general formula (XII) can be prepared by reacting the compound of general formula (XVII), chlorosulfonamide and amine compound of general formula (XIII).

R⁶-NH₂ (XIII)

X-A-COCl (XIV)

R⁶-SO₂-NH₂ (XV)

X-A-NCO (XVI)

X-A-COOH (XVII)

Also, the diol compounds of general formula (V), (VI) or (VII) in which Y represents sulfonylurethane group can be prepared by reacting one of hydroxy group of the trihydroxy compound with the compound of general formula (IX).

R⁶-SO₂-NCO (IX)

In addition, the diol compound of general formula (VIII) can be prepared by hydroxylating each compound obtained by the reaction of the compound of general formula (XIV) with the compound of general formula (XVIII), by the reaction of the compound of general formula (XVI) with the compound of general formula (XVIII), or by the reaction of the compound of general formula (XVII) with chlorosulfonamide and the compound of general formula (XIX).

X-B-SO₂-NH₂ (XVIII)

X-B-NH₂ (XIX)

wherein, X represents chlorine atom or bromine atom. In addition, A and B in general formulas (X) to (XIX) represent the same definitions as those of R³ to R⁵.

More specifically, examples of diol compounds include those represented by general formula (V), (VI), (VII), or (VIII).

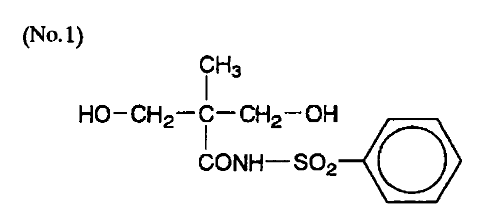

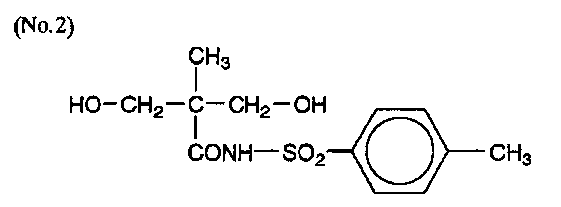

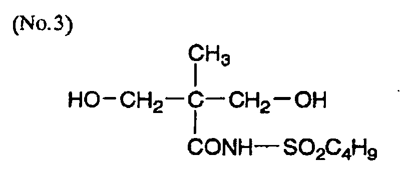

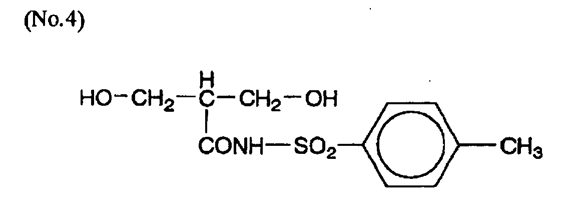

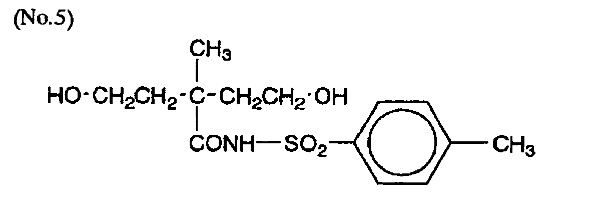

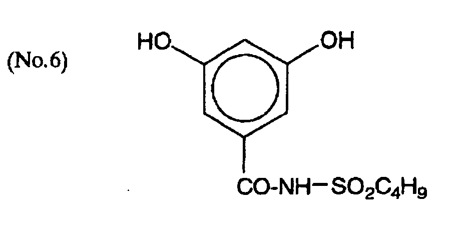

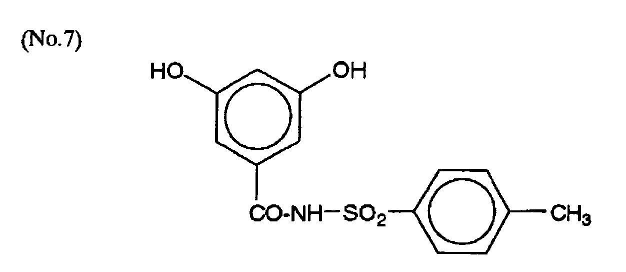

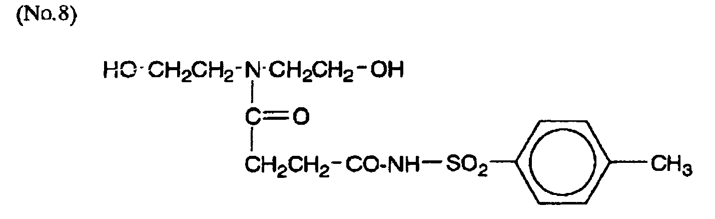

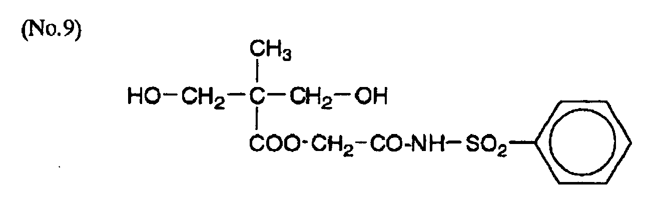

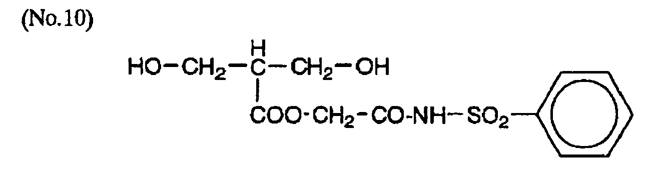

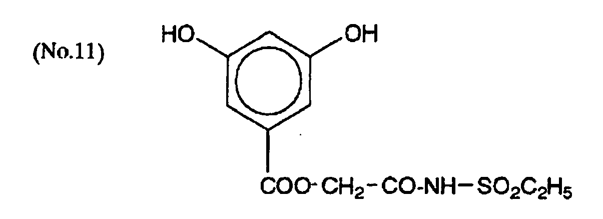

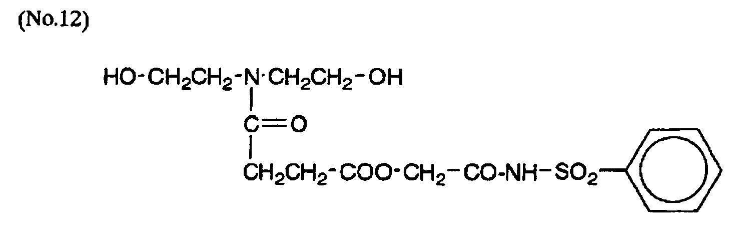

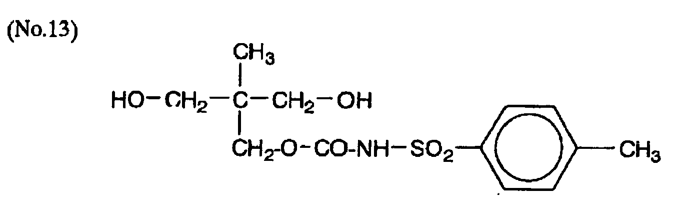

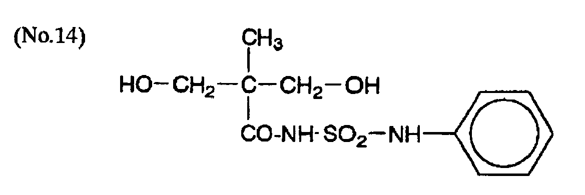

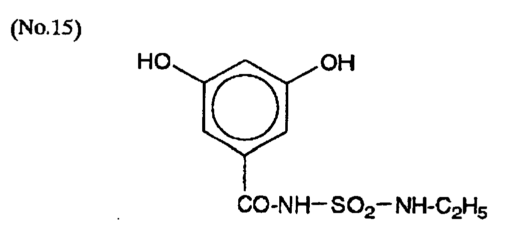

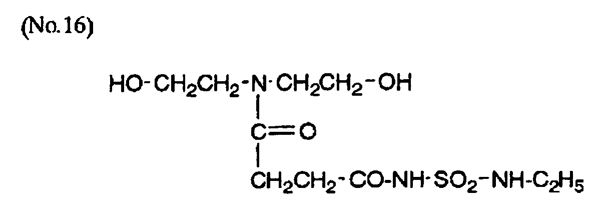

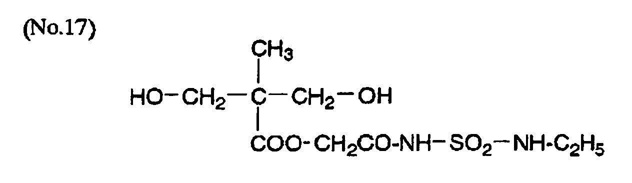

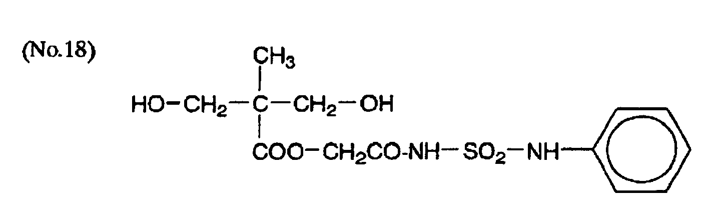

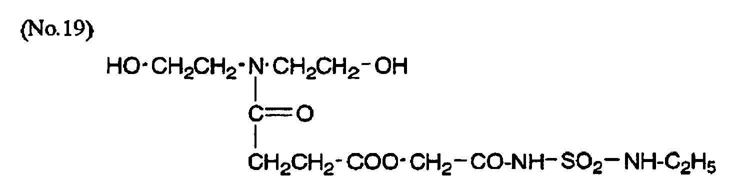

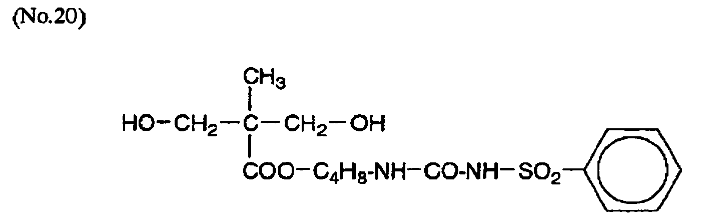

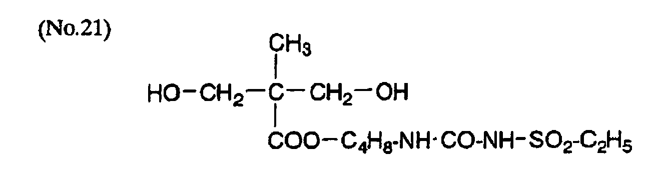

(No.22) HO-CH₂-CO-NH-SO₂-C₃H₆-OH

(No.23) HO-CH₂-CO-NH-SO₂-NH-C₂H₄-OH

(No.24) HO-C₃H₆-CO-NH-SO₂-NH-C₂H₄-OH

The polyurethane resin usable in the present invention also can be prepared by reacting a carboxyl group-containing polyurethane resin that is a reaction product of diisocyanate compound of general formula (I) and diol compound of general formula (VI), (VII), or (VIII) with the compound of general formula (IX), (X), (XI) or (XII) in the presence of base, or by reacting the carboxyl group-containing polyurethane resin with chlorosulfonylisocyanate followed by a reaction thereof with amine compound of general formula (XIII).

Further, it also may be possible to use additional diol compounds having a substituent that does not react with isocyanate group.

Examples of such diol compounds include ethylene glycol, diethylene glycol, triethylene glycol, tetraethylene glycol, propylene glycol, dipropylene glycol, polyethylene glycol, polypropylene glycol, neopentyl glycol, 1,3-butylene glycol, 1,4-butanediol, 1,5-pentanediol, 1,6-hexanediol, 2-butene-1,4-diol, 2-butyn-1,4-diol, 2,2,4-trimethyl-1,3-pentanediol, 2,2-diethyl-1,3-propanediol, 1,4-bis β -hydroxyethoxycyclohexane, cyclohexanediol, cyclohexanedimethanol, tricyclodecanedimethanol, hydrogenated bisphenol A, diethyl 2,2-dimethylolmalonate, bis(2-hydroxyethyl)sulfide, hydrogenated bisphenol F, ethylene oxide adduct of bisphenol A, propylene oxide adduct of bisphenol A, ethylene oxide adduct of bisphenol F, propylene oxide adduct of bisphenol F, ethylene oxide adduct of hydrogenated bisphenol A, propylene oxide adduct of hydrogenated bisphenol A, hydroquinonedihydroxy ethyl ether, p-xylylene glycol, dihydroxyethylsulfone, bis(2-hydroxyethyl)-2,4-tolylenedicarbamate, 2,4-tolylenebis(2-hydroxyethylcarbamide), bis(2-hydroxyethyl)-m-xylylenedicarbamate, and bis(2-hydroxyethyl)isophthalate.

The polyurethane resin usable in the present invention may further comprise a substituent -SO₂ NHCOO-, which has an acidic hydrogen atom and which can be introduced into the resin by reacting the residual -OH group of polyurethane resin with the compound of general formula (IX).

The polyurethane resin usable in the present invention can be prepared by heating the above-described diisocyanate compound and diol compound in an aprotic solvent in the presence of conventional catalysis suitable for each reaction such as diethylaniline, 2,2,2-diazabicyclooctane, and n-dibutyltin dilaurate. The molar ratio of diisocyanate and diol compounds is preferably in the range of 0.8:1 to 1.2:1. If any isocyanate group is remained at the end of polymer molecule, the polymer is further treated with alcohols or amines so that any isocyanate group is not remained.

The weight average molecular weight of the polyurethane resin of the present invention may be preferably 1000 or above and more preferably 5,000 to 150,000.

The polyurethane resin can be used alone or in combination. The amount of polyurethane resin to be used in layer (A) may be 25% by weight or more and preferably in the range of 30% to 90% by weight.

### (Diazo resin)

Hereinafter, diazo resin in layer (A) will be described.

Examples of diazo resin include a condensate of aromatic diazonium salt and active carbonyl group-containing compound such as formaldehyde as well as conventional diazo resins. Preferred resins among the foregoing diazo resins are those soluble in an organic solvent. Examples of diazo resin include an inorganic salt of diazo resin that is soluble in an organic solvent and is a reaction product of a condensate of p-diazodiphenylamine and formaldehyde or acetoaldehyde with hexafluorophosphate, or tetrafluoroborate, and an organic acid salt of diazo resin that is soluble in an organic solvent and is a reactin product of said condensate with sulfonic acids such as paratoluenesulfonic acid or salt thereof, with phosphinic acids such as benzenephoshpinic acid or salt thereof, or with hydroxyl group-containing compounds such as 2,4-dihydroxybenzophenone and 2-hydroxy-4-methoxybenzophenone-5-sulfonic acid or salts thereof as described in U.S. Patent No.3,300,309.

The total amount of diazo compounds in layer (A) may range 1 to 60% by weight, and preferably 3% to 50% by weight. Preferred example of other diazo resin usable in the present invention includes co-condensation product of an aromatic compound having at least one group selected from the group consisting of carboxyl group, hydroxy group, sulfonic acid group, sulfonate group, sulfinic acid group, and sulfinate group or an aromatic diazonium compound.

Examples of such aromatic compound may include, for example, benzene ring or naphthalene ring having at least one substituent selected from the group consisting of carboxyl group, hydroxy group, sulfonic acid group, sulfonate group, sulfinic acid group, and sulfinate group. Each substituent of such aromatic compound may be directly connected to aromatic ring, or may be connected to it through any connecting group. Examples of aromatic diazonium compounds may include 4-diazo-4'-methoxydiphenylamine salt, 4-diazo-4'-ethoxydiphenylamine salt and 4-diazo-3-methoxydiphenylamine salt, and 4-diazo-diphenylamine salt.

Examples of aromatic compounds include benzenesulfonic acid, sodium benzenesulfonate, disodium m-benzenedisulfonate, p-toluenesulfonic acid, sodium p-toluenesulfonate, p-toluenesulfinic acid, sodium p-toluenesulfinate, sodium benzenesulfinate, aniline-2-sulfonic acid, 4-amino-m-toluenesulfonic acid, sodium 4-amino-m-toluenesulfonate, 2,5-diaminobenzenesulfonic acid, 1-naphthalenesulfonic acid, 1-amino-2-naphthalenesulfonic acid, 5-amino-2-naphthalenesulfonic acid, 7-amino-1,3-naphthalenedisulfonic acid, 2-amino-1,5-naphthalenedisulfonic acid, sodium 4-amino-1-naphthalenesulfonate, sodium 5-amino-1-naphthalenesulfonate, sodium 6-amino-1-naphthalenesulfonate, sodium 5-sulfoisophthalate, 2-sulfobenzoic acid, p-chlorobenzenesulfonic acid, benzoic acid, o-chlorobenzoic acid, m-chlorobenzoic acid, p-chlorobenzoic acid, phthalic acid, terephthalic acid, diphenylacetic acid, phenoxyacetic acid, p-methoxyphenylacetic acid, p-methoxybenzoic acid, 2,4-dimethoxybenzoic acid, 2,4-dimethylbenzoic acid, p-phenoxybenzoic acid, 4-anilinobenzoic acid, 4-(m-methoxyanilino)benzoic acid, 4-(p-methoxybenzoyl)benzoic acid, 4-(p-methylanilino)benzoic acid, 4-phenylsulfonylbenzoic acid, phenol, (o,m,p)-cresol, xylenol, resorcin, 2-methylresorcin, (o,m,p)-methoxyphenol, m-ethoxyphenol, catechol, phloroglucin, p-hydroxyethylphenol, naphthol, pyrogallol, hydroquinone, p-hydroxybenzylalcohol, 4-chlororesorcin, biphenyl 4,4-diol, 1,2,4-benzenetriol, bisphenol A, 2,4-dihydroxybenzophenone, 2,3,4-trihydroxybenzophenone, p-hydroxyacetophenone, 4,4-dihydroxydiphenyl ether, 4,4-dihydroxydiphenylamine, 4,4'-dihydroxydiphenyl sulfide, cumylphenol, (o,m,p)-chlorophenol, (o,m,p)-bromophenol, salicylic acid, 4-methylsalicylic acid, 6-methylsalicylic acid, 4-ethylsalicylic acid, 6-propylsalicylic acid, 6-laurylsalicylic acid, 6-stearylsalicylic acid, 4,6-dimethylsalicylic acid, p-hydroxybenzoic acid, 2-methyl-4-hydroxybenzoic acid, 6-methyl-4-hydroxybenzoic acid, 2,6-dimethyl4-hydroxybenzoic acid, 2,4-dihydroxybenzoic acid, 2,4-dihydroxy-6-methylbenzoic acid, 2,6-dihydroxybenzoic acid, 2,6-dihydroxy-4-methylbenzoic acid, 4-chloro-2,6-dihydroxybenzoic acid, 4-methoxy-2,6-dioxybenzoic acid, gallic acid, phloroglucin carboxylic acid, 2,4,5-trihydroxybenzoic acid, m-galloyl gallic acid, tannic acid, m-benzoylgallic acid, m-(p-toluyl)gallic acid, protocatechuoyl-gallic acid, 4,6-dihydroxyphthalic acid, (2,4-dihydroxyphenyl)acetic acid, (2,6-dihydroxyphenyl)acetic acid, (3,4,5-trihydroxyphenyl)acetic acid, p-hydroxymethylbenzoic acid, p-hydroxyethylbenzoic acid, 4-(p-hydroxyphenyl)methylbenzoic acid, 4-(o-hydroxybenzoyl)benzoic acid, 4-(2,4-dihydroxybenzoyl)benzoic acid, 4-(p-hydroxyphenoxy)benzoic acid, 4-(p-hydroxyanilino)benzoic acid, bis(3-carboxy-4-hydroxyphenyl)amine, 4-(p-hydroxyphenylsulfonyl)benzoic acid, 4-(p-hydroxyphenylthio)benzoic acid. Preferred compounds are salicylic acid, p-hydroxybenzoic acid, p-methoxybenzoic acid, metachlorobenzoic acid, phenoxyacetic acid, benzenesulfonic acid, sodium benzenesulfonate, p-toluenesulfonic acid, sodium p-toluenesulfonate, p-toluenesulfinic acid, sodium p-toluenesulfinate, benzenesulfinic acid, sodium 5-sulfoisophthalate, 2-sulfobenzoic acid, 4-amino-m-toluenesulfonic acid, sodium 4-amino-m-toluenesulfonate, 1-naphthalenesulfonic acid, 2-amino-1,5-naphthalenedisulfonic acid, sodium 5-amino-1-naphthalenesulfonate, and p-chlorobenzenesulfonic acid.

The photosensitive diazo resin usable in the present invention can be obtained by polycondensation of said aromatic compound, aromatic diazonium salt or aldehydes such as paraformaldehyde, acetoaldehyde, and benzaldehyde or ketones such as acetone and acetophenone in sulfuric acid, phosphoric acid or hydrochloric acid, as described in Photo. Sci. Eng. Volume 17, page 33 (1973) and U.S. Patent Nos.2,063,631 and 2,679,498.

The molar ratio of the aromatic diazo compound and the aromatic compound ranges from 0.1:1 to 1:0.1, preferably from 0.5:1 to 1:0.2, and more preferably from 1:1 to 1:0.2. The diazo resin can be obtained by reacting said aromatic diazo compound and/or aromatic compound with aldehydes or ketones in a molar ratio of 0.6:1 to 1.5:1 and more preferably 0.7:1 to 1.4:1 (molar ratio of the total moles of aromatic diazo compound and/or aromatic compound and moles of aldehydes or ketones) at low temperature for short time (e.g., about 3 hours).

Next, counter anion X⁻ in diazo resin will be described. Preferred examples of X⁻ include aliphatic or aromatic sulfonic acid anion, and more preferably, anion of the following compounds or mixture thereof; methanesulfonic acid, fluoroalkanesulfonic acid (e.g., trifluoromethanesulfonic acid), laurylsulfonic acid, dioctylsulfosuccinic acid, dicyclohexylsulfosuccinic acid, camphor sulfonic acid, tolyloxy-3-propanesulfonic acid, nonylphenoxy-3-propanesulfonic acid, nonylphenoxy-4-butanesulfonic acid, dibutylphenoxy-3-propanesulfonic acid, diamylphenoxy-3-propanesulfonic acid, dinonylphenoxy-3-propanesulfonic acid, dibutylphenoxy-4-butanesulfonic acid, dinonylphenoxy-4-butanesulfonic acid, benzenesulfonic acid, toluenesulfonic acid, mesitylenesulfonic acid, p-chlorobenzenesulfonic acid, 2,5-dichlorobenzenesulfonic acid, sulfosalicylic acid, 2,5-dimethylbenzenesulfonic acid, p-acetylbenzenesulfonic acid, 5-nitro-o-toluenesulfonic acid, 2-nitrobenzenesulfonic acid, 3-chlorobenzenesulfonic acid, 3-bromobenzenesulfonic acid, 2-chloro-5-nitrobenzenesulfonic acid, butylbenzenesulfonic acid, octylbenzenesulfonic acid, decylbenzenesulfonic acid, dodecylbenzenesulfonic acid, butoxybenzenesulfonic acid, dodecyloxybenzenesulfonic acid, 2-methoxy-4-hydroxy-5-benzoylbenzenesulfonic acid, isopropylnaphthalenesulfonic acid, butylnaphthalenesulfonic acid, hexylnaphthalenesulfonic acid, octylnaphthalenesulfonic acid, butoxynaphthalenesulfonic acid, dodecyloxynaphthalenesulfonic acid, dibutylnaphthalenesulfonic acid, dioctylnaphthalenesulfonic acid, triisopropylnaphthalenesulfonic acid, tributylnaphthalenesulfonic acid, 1-naphthol-5-sulfonic acid, naphthaline-1-sulfonic acid, naphthaline-2-sulfonic acid, 1,8-dinitro-naphthalene-3,6-disulfonic acid, 4,4'-diazido-stilbene-3,3'-disulfonic acid, 1,2-naphthoquinone-2-diazido-4-sulfonic acid, 1,2-naphthoquinone-2-diazido-5-sulfonic acid and 1,2-naphthoquinone-1-diazido-4-sulfonic acid. Among these anions, preferred are anion of alkyl group-containing naphthalenesulfonic acid such as butylnaphthalenesulfonic acid, dibutylnaphthalenesulfonic acid, dioctylnaphthalenesulfonic acid, and tributylnaphthalenesulfonic acid.

The diazo resin usable in the present invention having a desired molecular weight can be prepared by controlling reaction conditions such as molar ratio of monomers and condensation condition. It is preferred that the diazo resin to be used in the present invention has weight-average molecular weight of about 400 to 100,000, and more preferably from about 800 to 5,000. The above-described photosensitive diazo resin is desirebly used in combination with a binder resin such as alkaline-soluble or swellable oleophilic polymeric compound.

### (Other components)

The foregoing layer (A) may further comprise a dye or pigment. Specific examples thereof are diphenylmethane, triphenylmethane, thiazine, oxazine, xanthene, anthraquinone, iminonaphthoquinone, azomethine or azo type dyes or titanium oxide, ferric oxide, carbon black, phthalocyanine, or azo type pigment. Further, layer (A) may comprise a printing out agents, for example, combinations of compounds releasing acids through exposure to light (photolytically acid-releasing agents) or photooxidative agents such as trihalomethyl compounds, diazo monomers, sulfonium salt, and iodonium salt with pH indicator or leuco dyes.

The photosensitive composition comprising the above-described polyurethane resin, diazo resin and optional components is dissolved or suspended in a proper solvent and is coated on a substrate.

The solvent usable in the present invention and the method for coating the layer can be the same as described for layer (B).

### [Layer (B)]

After forming the above-described layer (A) on a substrate, a composition comprising at least one polymer which is soluble or swellable in an alkaline water and which has at least two groups represented by general formula (A) on the side chain, at least one sensitizer as essential components and other optional components is dissolved or suspended in a proper solvent and is applied on the surface of layer (A) to form layer (B).

### (Alkaline water-soluble or swellable polymer compound)

The polymer which is soluble or swellable in an alkaline water and which has at least two groups represented by general formula (A) on the side chain will be described below. 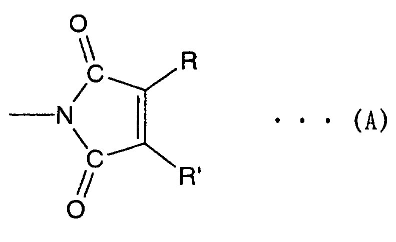 wherein, R and R' independently represents hydrogen atom, halogen atom or alkyl group, or R and R' may be linked together to form a 5- or 6-membered ring.

Preferable alkyl group of R and R' is those having 1 to 4 carbon atoms, and more preferably methyl group. Preferable ring that is formed by R and R' is 6-membered ring and more preferably aromatic or aliphatic 6-membered ring. Halogen atom includes chlorine atom, bromine atom or iodine atom.

In order to introduce the group represented by general formula (A) onto the side chain of a polymer, a monomer composition comprising at least one monomer represented by general formula (B), (C) or (D) can be used. 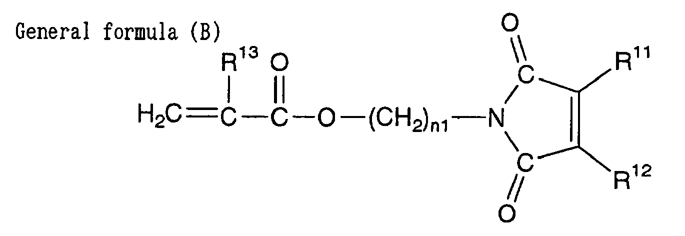 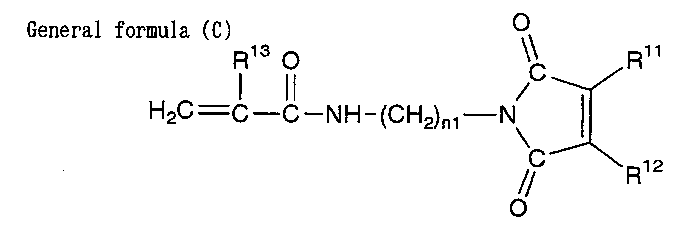 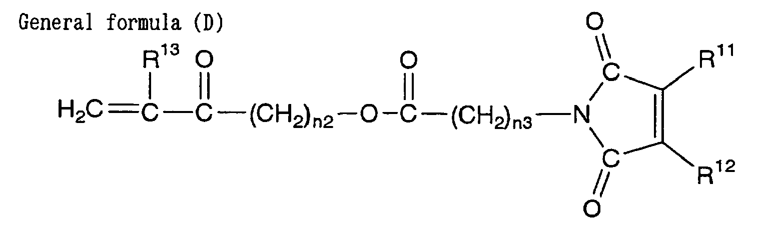 wherein, the definition of R¹¹ and R¹² are the same as R and R' of general formula (A), R¹³ represents hydrogen atom or methyl group, n1, n2 and n3 each represents an integer, preferably from 1 to 10 and more preferably from 1 to 6.

These polymers usable in the present invention are soluble or swellable in alkaline water since the presensitized plate of the present invention is preferably devleloped by an aqueous alkaline developer that substantially comprises no organic solvent in view of environmental safety. Therefore, the polymer may be a copolymer of monomers having at least one group represented by general formula (A) and monomers comprising at least one alkaline-soluble group. The polymer is obtainable by copolymerizing monomers comprising at least one group represented by general formula (A) on the side chain and monomers having at least one alkaline-soluble group.

As such alkaline-soluble group, an acid group having pKa at 14 or less is preferably used. Specific examples of monomers comprising such alkaline-soluble group include vinyl monomer having carboxyl group such as acrylic acid, methacrylic acid, maleic acid, and itaconic acid, vinyl monomer having - CONHSO₂- group as shown in the following formula (E), vinyl monomer having -SO₂NH- group as shown in the following formula (F), vinyl monomer having phenolic hydroxy group as shown in formula (G), vinyl monomer having phosphoric acid or phosphonic acid as shown in formula (H), maleic anhydride and itaconic anhydride. 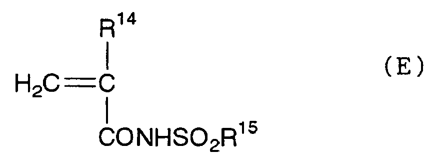 wherein, R¹⁴ represents hydrogen atom or methyl group; and R¹⁵ represents hydrocarbon group having 12 or less carbon atoms, which may be optionally substituted by, for example, alkyl, alkenyl, aralkyl, aryl, alkoxy, hydroxy and/or halogen group and more preferably, alkoxy, hydroxy and/or halogen group.

Preferable group as R¹⁵ includes methyl group, phenyl group and tolyl group, each of which is optionally substituted by, for example, alkyl, alkenyl, aralkyl, aryl, alkoxy, hydroxy and/or halogen group and more preferably, alkoxy, hydroxy and/or halogen group. 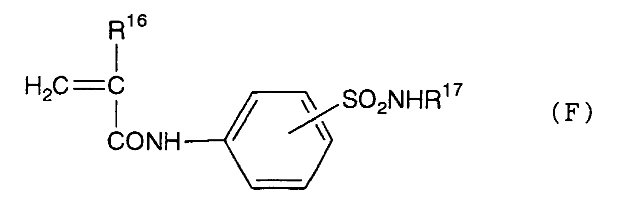 wherein, R¹⁶ represents hydrogen atom or methyl group; and R¹⁷ represents hydrogen atom or hydrocarbon group having 12 or less carbon atoms, each of which excepting hydrogen atome is optionally substituted by, for example, alkyl, alkenyl, aralkyl, aryl, alkoxy, hydroxy and/or halogen group and more preferably, alkoxy, hydroxy and/or halogen group.

Preferable group as R¹⁷ includes hydrogen atom, methyl group, phenyl group, and tolyl group, each of which excepting hydrogen atom is optionally substituted by, for example, alkyl, alkenyl, aralkyl, aryl, alkoxy, hydroxy and/or halogen group and more preferably, alkoxy, hydroxy and/or halogen group. 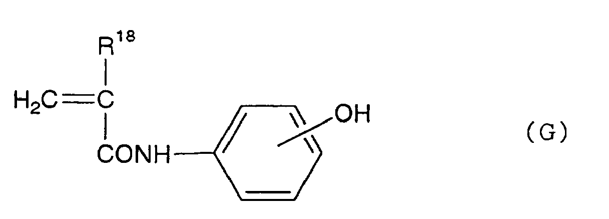 wherein, R¹⁸ represents hydrogen atom or methyl group. 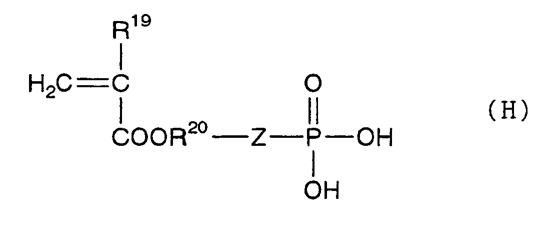 wherein, R¹⁹ represents hydrogen atom or methyl group, R²⁰ represents hydrocarbon connecting group having 12 or less carbon atoms which is optionally substituted by, for example, alkyl, alkenyl, aralkyl, aryl, alkoxy, hydroxy and/or halogen group and more preferably, alkoxy, hydroxy and/or halogen group, and Z represents oxygen atom or single bond.

Preferable group as R²⁰ includes C1∼C6 ethylene group and phenylene group, each of which is optionally substituted by, for example, alkyl, alkenyl, aralkyl, aryl, alkoxy, hydroxy and/or halogen group and more preferably, alkoxy, hydroxy and/or halogen group.

The polymer compound which is soluble or swellable in alkaline water and which has at least two groups represented by general formula (A) can be easily prepared by copolymerizing a monomer comprising an alkaline-soluble group and a monomer comprising maleimide groups represented by formula (A) in a ratio of 10/90 to 70/30 (molar ratio) and preferably from 20/80 to 60/40 (molar ratio). The acid value of the polymer is preferably from 30 to 500, and more preferably from 50 to 300. Among such polymers, a copolymer of N-[2-methacryloyloxy)alkyl]-2,3-dimethylmaleimide and methacrylic acid or acrylic acid as described in Die Angewandte Mackromolekulare Chemie 128(1984), pages 71 to 91 is useful. In the preparation of the copolymer, a third component, that is, a specific kind of vinyl monomer can be used to easily produce a multi-component copolymer depending on various pruposes. For example, if a homopolymer of alkyl methacrylate or alkyl acrylate having glass transition point of room temperature or below is used as the third component (i.e., vinyl monomer), the resulted copolymer may have flexibility.

The polymer which is soluble or swellable in alkaline water and has at least two groups represented by general formula (A) has preferably 1000 or higher of weight-average molecular weight, preferably from 10,000 to 500,000, and most preferably from 20,000 to 300,000.

The amount of polymer which is soluble or swellable in alkaline water and has at least two groups represented by general formula (A) in layer (B) is 30% by weight or more, and preferably from 50% to 98% by weight.

### (Sensitizer)

According to the present invention, layer (B) comprises a sensitizer. As such sensitizers, preferred are triplet sensitizers having a maximum absorption so that it practically imparts, to the light-sensitive layer, sufficient light absorption at a wavelength of not less than 300 nm. Examples of such sensitizers include benzophenone derivatives, benzanthrone derivatives, quinones, aromatic nitro compounds, naphthothiazoline derivatives, benzothiazoline derivatives, thioxanthones, naphthothiazole derivatives, ketocoumarin derivatives, benzothiazole derivatives, naphthofuranone compounds, pyrylium salts and thiapyrylium salts.

More specifically, such sensitizers include Michler's ketones, N,N'-diethylaminobenzophenone, benzanthrone, (3-methyl-1,3-diaza-1,9-benz)anthrone picramide, 5-nitroacenaphthene, 2-chlorothioxanthone, 2-isopropylthioxanthone, dimethylthioxanthone, methylthioxanthone-1-ethyl carboxylate, 2-nitrofluorene, 2-dibenzoylmethylene-3-methylnaphthothiazoline, 3,3-carbonylbis(7-diethylaminocoumarin), 2,4,6-triphenylthiapyrylium perchlorate and 2-(p-chlorobenzoyl)naphthothiazole, and sensitizers as described in J.P.KOKOKU Nos. Sho 45-8832, J.P. KOKAI No. Sho 52-129791, J.P. KOKAI No. Sho 62-294238, J.P. KOKAI No. Hei 2-173646, J.P. KOKAI No. Hei 2-131236, European Patent No. 368327, J.P. KOKAI No. Hei 2-236552, J.P. KOKAI No. Hei 3-54566, and J.P. KOKAI No. Hei 6-107718.

Among these sensitizers, peferred are those described in J.P. KOKAI No. Hei 2-236552, J.P. KOKAI No. Hei 3-54566, and J.P. Application No. Hei 4-259915, and more preferable sensitizers are those having at least one group selected from -COOH group, -NHSO₂R³⁰ group, -CONHCOR³⁰ group, and - CONHSO₂R³⁰ group (wherein, R³⁰ represents alkyl group, aromatic group or alkyl aromatic group) as an alkaline-soluble group, as disclosed in J.P. Application No. Hei 4-259915. The amount of the sensitizer desirably ranges from about 2% to about 15% by weight and preferably 3% to 10% by weight on the basis of the weight of layer (B).

### (Other components)

In addition to the above-described polymer and sensitizer, layer (B) preferably comprises an additional component that provides the plate with adhesiveness to the substrate as well as sufficient sensitivity and improved printing durability, such as diazo resin. Examples of such diazo resin include a co-condensation product of aromatic diazonium compound and aldehydes. Specific examples thereof include diazo resins as described in J.P.KOKOKU Nos. Sho 49-48001, Sho 50-7481, J.P.KOKOKU No. Hei 5-2227, J.P. KOKAI No. Hei 3-2864, J.P. KOKAI No. Hei 3-240061, and J.P. KOKAI No. Hei 4-274429.

Preferable examples thereof include diazo resin comprising at least one carboxyl group in its molecular, e.g., diazo resin prepared by co-condensation reaction of aromatic compound having at least one carboxyl group as described in J.P. KOKAI No. Hei 3-240061, and diazo resin prepared by condensation reaction of aldehyde having at least one carboxyl group as described in J.P. KOKAI No. Hei 3-2864. The amount of such diazo resin to be added may range from 0.1%to 30% by weight, preferably from 0.5% to 10% by weight and most preferably from 1% to 5% by weight based on the weight of composition for layer (B).

If desired, layer (B) may comprise a binder and such binder is usually selected from linear organic polymers. Specific examples of binders include known alkali-soluble polymers such as phenol/formaldehyde resin, cresol/form aldehyde resin, phenol-modified xylene resin, polyhydroxystyrene, polyhalogenized hydroxystyrene and carboxyl group-containing epoxy resin, polyacetal resin, acryl resin, methacryl resin, and carboxyl group-containing polyurethane resin. The amount of the alkali-soluble polymer may be 50% by weight or less based on the total amount of the composition.

The foregoing layer (B) may further comprise a variety of additives depending on the purposes. For example, polyfunctional monomer comprising at least two ethylenic double bonds that are capable of radical polymerization can be optionally added to layer (B) of the present invention. Specific examples of such compounds include ethylene glycol di(meth)acrylate, diethylene glycol di(meth)acrylate, polyethylene glycol di(meth)acrylate, hexanediol di(meth)acrylate, trimethylolethane tri(meth)acrylate, trimethylolpropane tri(meth)acrylate, and pentaerythritol (or dipentaerythritol) tri-, tetra- or hexa(meth)acrylate. The amount of these polyfunctional monomers to be added is 10% by weight or less based on the amount of the whole composition in the photosensitive layer.

In addition, layer (B) may further comprise a dye or pigment for the purpose of dyeing the photosensitive layer. Specific examples thereof are diphenylmethane, triphenylmethane, thiazine, oxazine, xanthone, anthraquinone, iminonaphthoquinone, azomethine or azo type dyes or titanium oxide, ferric oxide, carbon black, phthalocyanine, or azo type pigment. Also, printing out agents which are, for example, combinations of compounds releasing acids through exposure to light (photolytically acid-releasing agents) or photooxidative agents such as trihalomethyl compounds, diazo monomers, sulfonium salt, and iodonium salt with pH indicator or leuco dyes can be added to the photosensitive layer.

The photosensitive layer of the present invention may comprise a plasticizer. Examples of plasticizers usable in the invention are dialkyl phthalate such as dibutyl phthalate and dihexyl phthalate; oligoethylene glycol alkyl esters or phosphoric acid esters. Also, the photosensitive layer may further comprise various acidic compounds as a stabilizer for the diazo resin, and acid group-containing compounds that is soluble in alkaline water for improving the developability thereof. In addition, it is possible to modify the property of the surface of photosensitive layer by adding thereto an agent for desensitizing the plate to grease, surfactant, fluorine atom-containing compound, or silicious compound.

Moreover, layer (B) may preferably comprise a heat polymerization inhibitor and an antioxidant. Specific examples thereof effectively used are hydroquinone, p-methoxyphenol, di-t-butyl-p-cresol, pyrogallol, t-butylcatechol, benzoquinone, 4,4'-thiobis(3-methyl-6-t-butylphenol), 2,2'-methylenebis(4-methyl-6-t-butylphenol) and 2-mercaptobenzimidazole.

### (Coating method)

Layer (B) of the presensitized plate of the present invention can be applied on a substrated by dissolving the above-described components in a solvent. Such solvents include methanol, ethanol, isopropylalcohol, n-butylalcohol, t-butylalcohol, ethylene dichloride, cyclohexanone, acetone, methyl ethyl ketone, ethylene glycol, ethylene glycol monomethyl ether, ethylene glycol monoethyl ether, 2-methoxyethyl acetate, 1-methoxy-2-propanol, 1-methoxy-2-propyl acetate, N,N-dimethylformamide, tetrahydrofuran, dioxane, dimethylsulfoxide, ethyl acetate, methyl lactate, and ethyl lactate. These solvents can be used alone or in combination. Also, small amount of water can be added to these solvents or mixture thereof. The concentration of solid components in a solvent ranges from 1% to 50% by weight.

The coating applied with such solvent is desirebly dried at 50 to 120°C. The drying process may comprise predrying at low temperature followed by drying at high temperature. Also, it may be possible to directly dry the coating using a proper solvent and concentration.

### [Mat layer]

A mat layer is preferably applied onto the surface of the photosensitive layer thus formed to reduce the time required for evacuation during contact exposure using a vacuum printing frame and to prevent the formation of an indistinct image during printing. Examples of such mat layers are disclosed in J.P. KOKAI Nos. Sho 50-125805 and Sho 58-182636, and J.P. KOKOKU Nos. Sho 57-6582. Alternatively, the mat layer can also be formed by heat-welding solid powder onto the surface of the photosensitive layer as disclosed in J.P. KOKOKU No. Sho 62-62337.

### [Substrate]

The substrate usable for the preparation of presensitized plate of the present invention is an aluminum plate having a hydrophilic surface, which is conventionally used as a substrate for a presensitized plate. Aluminum plate is preferred because of their high dimensional stability, low cost and good adhesion to the photosensitive layer used in the invention.

The aluminum plate used in the present invention essentially comprises a hydrophilic surface. Therefore, the surface of the plate is preferably subjected to surface-treatement such as graining and anodizing. Also, it is preferable to dip the plate into an aqueous solution of sodium silicate, potassium fluorozirconate or phosphoric acid salt. Further, preferable aluminum plates include, for instance, those that are grained and then immersed in an aqueous solution of sodium silicate as disclosed in U.S. Patent No. 2,714,066; and those that are anodized and then dipped in an aqueous solution of an alkali metal silicate as disclosed in J.P.KOKOKU No. Sho 47-5125.

It is also efective to subject the aluminum substrate to silicate electrodeposition as disclosed in U.S. Patent No. 3,658,662. Moreover, it is likewise effective to adopt a combination of electrolytic graining, the aforementioned anodization and a sodium silicate treatment as disclosed in J.P. KOKOKU No. Sho 46-27481 and J.P. KOKAI Nos. Sho 52-58602 and Sho 52-30503. Preferred aluminum substrates further include those which are subjected, in order, to brush graining, electrolytic graining, anodization and sodium silicate treatments. Those obtained by applying an underlying layer onto the aluminum substrates thus treated are also preferred. The underlying layer may comprise a water-soluble resin such as polymer or copolymer having, on the side chains, polyvinyl phosphonic acid and sulfonic acid, and polyacrylic acid. In addition, those described in J.P. KOKAI No. Hei 2-23348 and J.P. Application No. Hei 2-151858 are also preferred. These hydrophilization treatments are performed not only for making the surface of the substrate hydrophilic but also for preventing the occurrence of any detrimental reaction with the photosensitive composition applied thereon and for enhancing the adhesion between layer (A) and layer (B).

The presensitized plate of the present invention is subjected to imagewise exposure to light from light source rich in ultraviolet rays such as metal halide lamp and high pressure mercury lamp and then is developed with a developer to remove the un-exposed areas of the photosensitive layer and finally coated with a gumming up solution to thus give a lithographic printing plate.

### [Development]

Examples of developer which can be used for developing the presensitized plate of the present invention include an aqueous solution containing an inorganic alkaline agent such as sodium silicate, potassium silicate, sodium hydroxide, potassium hydroxide, lithium hydroxide, sodium tertiary phosphate, sodium secondary phosphate, ammonium tertiary phosphate, ammonium secondary phosphate, sodium metasilicate, sodium bicarbonate or aqueous ammonia and an aqueous solution of organic amine compound such as mono, di or triethanolamine. Such alkaline agent may be used in the developer in an amount of 0.1% to 10% by weight and preferably 0.5% to 5% by weight.

The alkaline aqueous solution may comprise, if necessary, a surfactant and/or an organic solvent such as an alcohol. Preferred examples of the organic solvents are benzyl alcohol, 2-phenoxyethanol, 2-butoxyethanol and n-propyl alcohol. Examples of surfactant include anionic surfactant such as alkylnaphthalenesulfonate, and sodium laurylsulfate. In addition, it is also preferred to add, to the developer solutions, an agent for solubilizing the diazo resin and/or a reducing substance such as sulfites, methylresorcin or pyrazolone compounds. In addition to the developers listed above, those disclosed in U. S. Patent Nos. 3,615,480 and 3,475,171 and those disclosed in J.P. KOKAI No. Sho 50-26601 and J.P. KOKOKU Nos. Sho 56-39464 and Sho 56-42860 are effectively used for developing the PS plates of the present invention.

However, the developer comprising any organic solvent may cause many problems (e.g., problems on health such as toxicity and odour during work, on safety such as fire and gaseous explosion, on workability such as generation of foam, on environmental polloution such as waste water, and on cost). Therefore, it is preferable that the developer substantially comprises no organic solvent.

The phrase "substantially comprises no organic solvent" means that the amount of organic solvent in the developer does not exceed the amount that cause aforementioned disadvantages to health, safety, workability and the like. In the present invention, the amount of organic solvent in the composition is 2% by weight or less and preferably 1% by weight or less.

For example, a developer composition for positive-working presensitized plate as disclosed in J.P. KOKAI No. Sho 59-84241 and J.P. KOKAI No. Sho 57-192952 can be used as such aqueous alkaline developer substantially comprinsg no organic solvent.

It is contemplated that the presensitized plate of the present invention is used to make a lithographic printing plate by the method as described in J.P. KOKAI Nos. Sho 54-8002 and Sho 55-115045, J.P. KOKAI No. Sho 59-58431. That is, after developing the plate, it can be washed with water and then treated to desensitize the plate to grease, directly treated to desensitize the plate to grease, treated with water comprising acid, or treated to desensitize the plate to grease after the treatment with water comprising acid. In addition, if developability of the developer is lowered because of decrease of the alkaline concentration due to consumption of aqueous alkaline solution in an amount used for development or due to contamination of air after running automatic developing machine for long time, the developability of the developer can be recovered using replenisher or replenishing method as described in J.P. KOKAI Nos. Sho 54-62004, Sho 55-22759, Sho 55-115039, Sho 56-12645, Sho 58-95349, and Sho 64-21451, and J.P. KOKAI Nos. Hei 1-180548, and Hei 2-3065.

In addition, such process for making a lithographic printing plate is preferably conducted using automatic developing machine as described in J.P. KOKAI Nos. Hei 2-7054 and Hei 2-32357. Furthermore, a gum for providing the plate with an insensitivity to oil or grease can be optionally applied in the final step of the prepartion process of lithographic printing plate and preferred examples of such gum include those as described in J.P.KOKOKU Nos. Sho 62-16834, Sho 62-25118, and Sho 63-52600, and J.P. KOKAI Nos. Sho 62-7595, Sho 62-11693, and Sho 62-83194.

Also, it is possible to conduct, if necessary, removement of images, washing with water, and/or treatment to desensitize the plate to grease after development, or to conduct re-exposure to light or burning treatment in order to improve the strength of the images.

### [Examples]

The present invention will hereunder be explained in more detail with reference to the following non-limitative working Examples In the following description, the term "%" means "% by weight" unless otherwise specified.

### Example 1

Surface of a 1S aluminum plate having thickness of 0.24 mm was grained with nylon brush with a suspension of 400 mesh pumice stone in water and then fully washed with water. The plate was immersed in an aqueous solution of 20% sodium hydroxide at 70°C for 60 seconds to etch the plate and washed with water. Then the plate was washed with 20% HNO₃ to neutralize it and again washed with water. Next, electrolytic graining of the plate was conducted in 1% aqueous nitric acid solution using rectangle alternating waved current with V_{A}=12.7 V and V_{C}=9.1V and in a quantity of electricity at the anode of 170 coulomb/dm². The plate was then immersed in 25% aqueous NaOH soultion at 45°C for 15 seconds to conduct etching of the plate. Further, the plate was immersed in 30% aqueous H₂SO₄ solution at 55 °C for 2 minutes to conduct desmut treatment. The plate was then anodized in 7% aqueous H₂SO₄ solution till the amount of anodized layer becase 1.8 g/cm². Then the plate was immersed in 3% aqueous sodium silicate solution at 70°C for 1 minute, washed with water and dried to obtain a substrate having a hydrophilized surface.

The surface of thus obtained plate was then coated with Coating solution (A) for photosensitive layer using a bar and dried for 30 seconds at 80°C. The amount of the layer after dried was 0.1 g/m².

### (Coating solution (A) for photosensitive layer)

| | |
|---|---|
| ·Polyurethane resin of 4,4'-diphenylmethane diisocyanate /hexamethylene diisocyanate/2,2-bis(hydroxymethyl)propionic acid/tetraethylene glycol = 50/50/90/10 (molar ratio) (weight-average molecular weight 100,000) (hereinafter, referred to as polyurethane resin "a1") | 1.0g |
| ·Co-condensate diazo resin of 4-diazo-3-methoxydiphenylamine· dodecylbenzenesulfonate /phenoxyacetic acid = 5/5 (molar ratio) (hereinafter, referred to as diazo resin "b1") | 0.3g |
| ·Megafac F-176 (fluorine atom-containing surfactant, Dainippon Ink and | |
| Chemicals, Inc) | 0.05g |
| ·Methyl ethyl ketone | 50g |
| ·Methanol | 50g |

Thus obtained plate was further coated with the following Coating solution (C) for photosensitive layer using a bar and dried at 100°C for 1 minute. The total amount of the coatings after being dried including the amount of a layer prepared from Coating solution (A) for photosensitive layer (A) was 1.0g/m².

### (Coating solution (C) for photosensitive layer)

| | |
|---|---|
| ·Copolymer of N-[6-(methacryloyloxy)hexyl]-2,3-dimethylmaleimide/methacrylic acid = 60/40 (molar ratio) | 5.0g |
| ·Sensitizer having the structure described below | 0.3g |
| ·Co-condensate of 4-diazodiphenylamine · dodecylbenzenesulfonate/phenoxyacetic acid = 5/5 (molar ratio) (hereinafter, referred to as diazo resin "c1") | 0.3g |
| ·4-diazo-3-methoxydiphenylamine·hexafluorophosphate | 0.2g |
| ·Victoria Pure BlueBOH (Hodogaya Chemical Co., Ltd.) | 0.1g |
| ·Megafac F-177 (fluorine atom-containing surfactant, Dainippon Ink and Chemicals, Inc) | 0.1g |
| ·Propylene glycol monomethyl ether | 50g |
| ·Methyl ethyl ketone | 50g |
| ·Methanol | 20g |

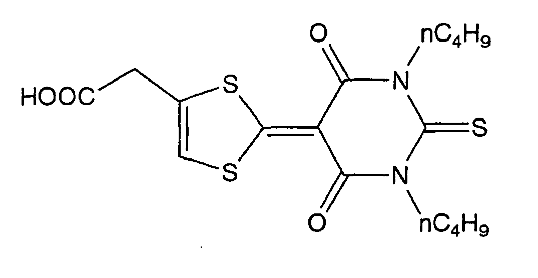

Thus obtained presensitized plate was imagewise exposed using "printer FT26V2UPNS" (available from Nuaku, Co. Ltd., in U.S.A, light source; 2KW metal halide lamp) with 200 counts, with a Step Tablet (comprising 15 steps and having a optical density difference of 0.15) and a negative image film closely contacted to the plate. Then, the plate was treated with "Developer (A)" at 30°C for 15 seconds. The surface of the plate was rubbed with cotton and then washed with water. Further the plate was treated with the following composition for desensitizing to grease to obtain a lithographic printing plate. Thus obtained plate is referred to as printing plate [1].

### Developer (A)

| | |
|---|---|
| · Aqueous potassium silicate solution (of which molar ratio of [SiO₂]/[K₂O] is 1.2 and SiO₂ concentration is 2.1% by weight) | 999g |
| ·Ethylenediaminetetraacetic acid disodium salt | 1g |

### Composition for desensitizing to grease

| | |
|---|---|
| ·Gum arabic | 5g |
| ·White dextrin | 30g |
| ·Ethylene glycol | log |
| ·Phosphoric acid | 3g |
| ·Water | 952g |

Thus prepared lithographic printing plate was set on a printer (LITHRONE, Komori Printer Co. Ltd.) to conduct continuous printing with commertially available ink on quality papers to evaluate printing durability of the plate.

The results are shown in Table 2. Details of the evaluation method for the results in Table 2 are described below.
·"Sensitivity (highest step number)" indicates the highest step number the Step Tablet at which image is remained after development. When the step number of one plate is 2 steps higher than that of another plate, the former plate has twofold higher sensitivity than that of of the latter plate.
· "Printing durability (number of printed copies)" means the total number of copies obtained by the plate. The printing process was stopped when it was observed that ink does not sufficiently adhere to an image area in a copy or that ink adheres to a non-image area. The larger number of copies indicates higher printing durability.

### Example 2

The aluminum substrate as obtained in Example 1 was coated with the following Coating solution (B) for photosensitive layer using a bar and dried at 80°C for 30 seconds. The amount of the layer after dried was 0.2 g/m².

### (Coating solution (B) for photosensitive layer)

| | |
|---|---|
| ·Polyurethane resin of 4,4'-diphenylmethane diisocyanate /hexamethylene diisocyanate/2,2-bis(hydroxymethyl)propionic acid = 80/20/100 (molar ratio) (weight-average molecular weight; 80,000) (hereinafter, referred to as polyurethane resin "a2") | 0.6g |
| ·Co-condensate diazo resin of 4-diazodiphenylamine· dibutylnaphthalenesulfonate/phenoxyacetic acid = 4/6 (molar ratio) (hereinafter, referred to as diazo resin "b2") | 0.2g |
| ·4-Diazo-3-methoxydiphenylamine · hexafluorophosphate | 0.4g |
| ·Victoria Pure Blue BOH (Hodogaya Chemical Co., Ltd.) | 0.2g |
| ·Megafac F-177 (fluorine atom-containing surfactant, Dainippon Ink and Chemicals, Inc) | 0.1g |
| ·Methyl ethyl ketone | 20g |
| ·Methanol | 80g |

Thus obtained plate was further coated with the following Coating solution (D) for photosensitive layer using a bar and dried at 100°C for 1 minute. The total amount of coatings including the amount of the layer prepared from Coating solution (B) for photosensitive layer after dried was 1.5 g/m².

### (Coating solution (D) for photosensitive layer)

| | |
|---|---|
| · Copolymer of N-[6-(methacryloyloxy)hexyl]-2,3-dimethylmaleimide /methacrylic acid = 60/40 (molar ratio) | 5.0g |
| ·Sensitizer having a structure described below | 0.3g |
| ·Diazo resin comprising 4-diazodiphenylamine · dodecylbenzenesulfonate (hereinafter, referred to as diazo resin "c2") | 0.3g |
| ·Megafac F-177 (fluorine atom-containing surfactant, Dainippon Ink and Chemicals, Inc) | 0.1g |
| ·Propylene glycol monomethyl ether | 50g |
| ·Methyl ethyl ketone | 50g |
| ·Methanol | 20g |

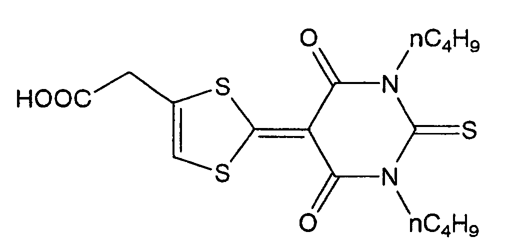

Thus obtained presensitized plate was further subjected to exposure to light, development and treatment of desensitizing the plate to grease as described in Example 1. Thus obtained plate is referred to as printing plate [2].

### Examples 3 to 10

Printing plates [3] to [10] were prepared as in Example 1 excepting that polyurethane resin "a", diazo resins "b" and "c", the dry weight of first layer, and total dry weight of first layer and second layer were changed as shown in Table 1.

In Table 1, the following terms are used for the components of resin.
DPDI: 4,4'-diphenylmethane diisocyanate
HMDI: hexamethylene diisocyanate
BHP: 2,2'-bis(hydroxymethyl)propionic acid
TEG: tetraethylene glycol
TMDI: tetramethylene diisocyanate
DMDA·DBS: 4-diazo-3-methoxydiphenylamine· dodecylbenzenesulfonate
DDA·DNS: 4-diazodiphenylamine·dibutylnaphthalenesulfonate
DDA·DBS: 4-diazodiphenylamine·dodecylbenzenesulfonate
DMDA·DNS: 4-diazo-3-methoxydiphenylamine· dibutylnaphthalenesulfonate
PAA: phenoxyacetic acid

| Ex. No. | Layer (A) | | | | | Layer (B) | | Total dry weight of A/B layers (g/cm²) |
|---|---|---|---|---|---|---|---|---|
| | CSPL* | Components of polyurethane resin "a" (molar ratio) | WAMW * | Components of diazo resin "b" (molar ratio) | Dry weight (g/cm²) | CSPL* | Components of diazo resin "C" (molar ratio) | |
| 1 | A | DPDI/HMDI/BHP /TEG=50/50/90/10 | 100,000 | DMDA·DBS/PAA=5 /5 | 0.10 | C | DDA·DBS/PAA=5/5 | 1.50 |
| 2 | B | DPDI/HMDI/BHP =80/20/100 | 80,000 | DDA·DNS/PAA=4/6 | 0.30 | D | DDA·DBS | 1.50 |
| 3 | A | DPDI/HMDI/BHP = 80/20/100 | 80,000 | DDA·DNS/PAA=4/6 | 0.60 | C | None | 1.80 |
| 4 | A | DPDI/HMDI/BHP /TEG=50/50/90/10 | 100,000 | DDA·DNS/PAA=4/6 | 0.15 | C | DDA·DNS/PAA=4/6 | 1.00 |
| 5 | A | DPDI/HMDI/BHP =30/70/100 | 200,000 | DDA·DBS/PAA=5/5 | 0.40 | C | DDA·DBS | 0.90 |
| 6 | A | DPDI/HMDI/BHP /TEG=90/10/80/20 | 150,000 | DDA·DBS/PAA=5/5 | 0.20 | C | DDA·DNS/PAA=4/6 | 1.30 |
| 7 | A | DPDI/TMDI/BHP/ TEG=90/10/80/20 | 300,000 | DDA·DNS/PAA=4/6 | 0.03 | C | DDA·DNS/PAA=4/6 | 2.50 |
| 8 | B | DPDI/HMDI/BHP = 30/70/100 | 200,000 | DDA·DNS/PAA=4/6 | 0.20 | D | None | 2.00 |
| 9 | B | DPDI/HMDI/BHP /TEG=50/50/90/10 | 100,000 | DDA·DNS/PAA=4/6 | 0.10 | D | DDA·DNS/PAA=4/6 | 1.00 |
| 10 | B | DPDI/TMDI/BHP/ TEG=90/10/80/20 | 300,000 | DDA·DBS/PAA=5/5 | 0.50 | D | DDA·DBS | 1.30 |

| | | | | | | | | |
|---|---|---|---|---|---|---|---|---|
| WAMW*: Weight-average molecular weight CSPL*: Coating solution for photosensitive layer | | | | | | | | |

### Comparative Example 1

The process of Example 1 was repeated except that only Coating solution (C) for photosensitive layer was used and Coating solution (A) for photosensitive layer was not used to obtain printing plate [Comp. 1].

### Comparative Example 2

The process of Example 1 was repeated except that polyuretan resin "a1" in Coating solution (A) for photosensitive layer was not used to obtain printing plate [Comp. 2].

### Comparative Example 3

The process of Example 1 was repeated except that diazo resin "b1" in Coating solution (A) for photosensitive layer was not used to obtain printing plate [Comp. 3].

### Comparative Example 4

The process of Example 1 was repeated except that Coating solution (E) for photosensitive layer was used in place of Coating solution (A) for photosensitive layer to obtain printing plate [Comp. 4].

### (Coating solution (E) for photosensitive layer)

| | |
|---|---|
| · Copolymer of N-(p-aminosulfonylphenyl)methacrylamide/methyl methacrylate/acrylonitrile = 35/35/30 (molar ratio) (weight-average molecular weight: 90,000) | 1.0g |
| · Co-condensate diazo resin of 3-methoxy-4-diazophenylamine dodecylbenzenesulfonate/phenoxyacetic acid = 5/5 (molar ratio) | 0.3g |
| ·Megafac F-176 (fluorine atom-containing surfactant, Dainippon Ink and Chemicals, Inc) | 0.05g |
| ·Acetone | 70g |
| ·Methanol | 30g |

### Comparative Example 5

The process of Example 2 was repeated except that Coating solution (F) for photosensitive layer was used in place of Coating solution (B) for photosensitive layer to obtain printing plate [Comp. 5].

### (Coating solution (F) for photosensitive layer)

| | |
|---|---|
| ·Copolymer of N-(p-aminosulfonylphenyl)acrylamide/butyl acrylate/methoxytetraethylene glycol methacrylate = 45/40/15 (molar ratio) (weight-average molecular weight 80,000) | 1.0g |
| · Co-condensate diazo resin of 4-diazodiphenylamine dibutylnaphthalenesulfonate/phenoxyacetic acid = 4/6 (molar ratio) | 0.2g |
| · 4-Diazo-3-methoxydiphenylamine · hexafluorophosphate | 0.4g |
| ·Victoria Pure Blue BOH (Hodogaya Chemical Co., Ltd.) | 0.2g |
| ·Megafac F-177 (fluorine atom-containing surfactant, Dainippon Ink and Chemicals, Inc) | 0.1g |
| ·Gamma butyrolactone | 80g |
| ·Methanol | 20g |

Evaluation of printing plates prepared in Examples 2 to 10 and Comparative Examples 1 to 5

The printing plates prepared as described above were evaluated as in Example 1. The results are shown in Table 2. In these experiments, every printing plates were developed well and there was no scum at non-image area after development. As seen from Table 2, the printing plates of Examples 1 to 10 show high sensitivity and high printing durability.

In contrast, printing plate [Comp. 1] that does not have layer (A) and is comprised of single layer, printing plate [Comp. 2] that contains layer (A) which only comprises diazo resin, printing plate [Comp. 3] that contains layer (A) which only comprises polyurethane resin, and printing plates [Comp. 4] and [Comp. 5] that contains layer (A) which comprises acrylic copolymer in place of polyurethane resin were lower sensitivity and printing durability and thus, these plates do not show sufficient properties for lithographic printing plates.

### Example 11

The process of Examples 1 to 10 were repeated except that the following developer (B) was used in each developing process to obtain the corresponding printing plates.

### (Developer (B))

| | |
|---|---|
| ·D-sorbitol | 25g |
| ·Potassium hydroxide | 13g |
| ·Pentasodium diethylenetriaminepenta(methylenesulfonate) | 1g |
| ·Water | 961g |

These plates were evaluated as described above. The sensitivity of each plate was almost the same as those of Examples 1 to 10. The difference of printing durability between the plates of Example 11 and of Examples 1 to 10 is within ±5000 copies and therefore, it is considered that the plates of Example 11 have also good printing durability.

**Table 2**

| Lithographic printing plate | Sensitivity (highest step number) | Printing durability (number of printed copies) |
|---|---|---|
| 1 | 10 | 80000 |
| 2 | 11 | 100000 |
| 3 | 9 | 80000 |
| 4 | 10 | 100000 |
| 5 | 11 | 100000 |
| 6 | 10 | 90000 |
| 7 | 10 | 110000 |
| 8 | 9 | 80000 |
| 9 | 10 | 100000 |
| 10 | 11 | 110000 |
| Comp.1 | 7 | 30000 |
| Comp.2 | 7 | 40000 |
| Comp.3 | 5 | 20000 |
| Comp.4 | 8 | 50000 |
| Comp.5 | 8 | 50000 |

### [Effect of the Invention]

The present invention provides a presensitized plate useful for preparing a lithographic printing plate comprising layer (A) coated on an aluminum substrate having a hydrophilized surface, and layer (B) coated on said layer (A), wherein layer (A) comprises at least one polyurethane resin having an acidic hydrogen atom and at least one diazo resin and layer (B) comprises at least one sensitizer and at least one polymer which is soluble or swellable in an alkaline water and which has at least two groups represented by the following general formula (A) on the side chain. The presensitized plate of the present invention can be used for preparing a lithographic printing plate having high sensitivity and high printing durability.

## Claims

1. A presensitized plate useful for preparing a lithographic printing plate comprising layer (A) coated on an aluminum substrate having a hydrophilized surface and layer (B) coated on said layer (A), wherein layer (A) comprises at least one polyurethane resin having at least one acidic hydrogen atom and at least one diazo resin and layer (B) comprises at least one sensitizer and at least one polymer which is soluble or swellable in an alkaline water and which has at least two groups represented by the following general formula (A) on the side chain. 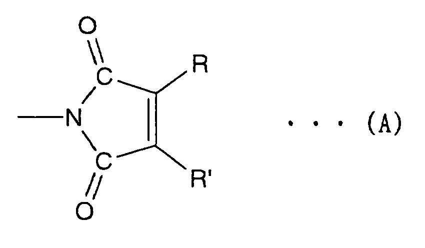 wherein, R and R' independently represents hydrogen atom, halogen atom, or alkyl group, or R and R' may be linked together to form a 5- or 6-membered ring.

2. The presensitized plate of claim 1, wherein the polyurethane comprising at least one acidic hydrogen atom is a member selected from the group consisting of polyurethane resins having at least one -COOH, -SO₂NHCOO-, -CONHSO₂-, -CONHSO₂NH-, or -NHCONHSO₂-.

3. The presensitized plate of claim 1 or 2, wherein the acid value ranges from 0.05 to 6 milliequivalents per 1 g of the polyurethane resin.

4. The presensitized plate of any one of claims 1 to 3, wherein the polyurethane resin is obtainable by reacting a diisocyanate compound represented by general formula (I) with a diol compound represented by general formula (II), (III) or (IV);
OCN-R¹-NCO (I) 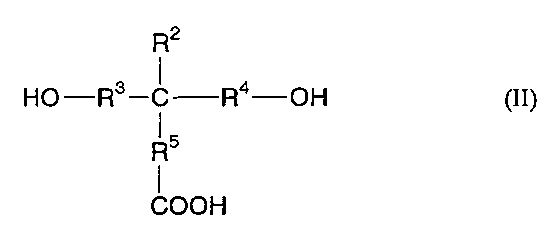 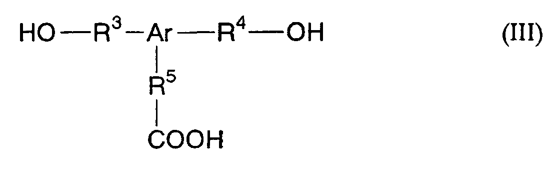 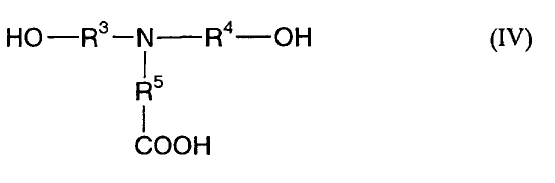
wherein, R¹ represents bivalent aliphatic or aromatic hydrocarbon each of which is optionally substituted by alkyl, alkenyl, aralkyl, aryl, alkoxy and/or halogen group; R² represents hydrogen atom, alkyl, alkenyl, aralkyl, aryl, alkoxy, or aryloxy group each of which is optionally substituted by alkyl, aryl, alkoxy, ester, urethane, amide, ureido and/or halogen group; R³, R⁴ and R⁵ may be the same or different and each represents single bond, bivalent aliphatic or aromatic hydrocarbon each of which is optionally substituted by alkyl, alkenyl, aralkyl, aryl, alkoxy and/or halogen; and Ar represents trivalent aromatic hydrocarbon which is optionally substituted by alkyl, aryl, alkoxy, ester, urethane, amide, ureido and/or halogen group.

5. The presensitized plate of any one of claims 1 to 3, wherein the polyurethane resin is obtainable by reacting a diisocyanate compound represented by general formula (I) with a diol compound represented by general formula (V), (VI), (VII) or (VIII); 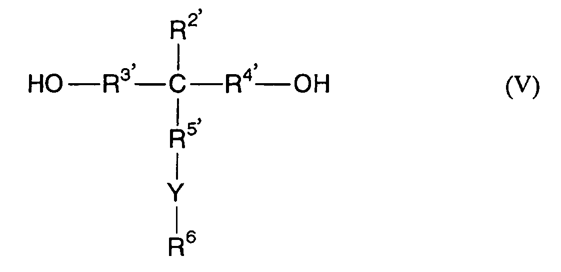 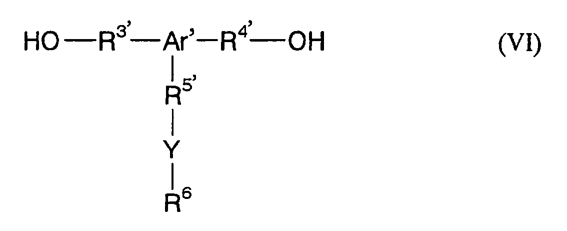 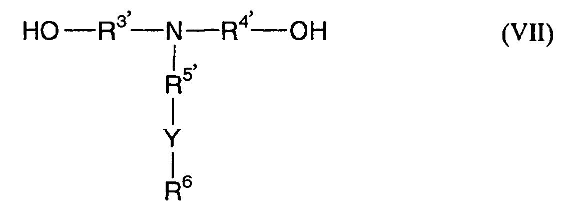
HO-R^{3'}-Y-R^{4'}-OH (VIII)
wherein, the definitions of R^{2'}, R^{3'}, R^{4'}, R^{5'} and Ar' are the same as those of R², R³, R⁴, R⁵ and Ar as in claim 4; R⁶ represents monovalent aliphatic or aromatic hydrocarbon which is optionally substituted by alkyl, alkoxy and/or halogen atom; and Y represents -sulfonylamide group (-CO-NH-SO₂-), N-sulfonylureido group (-NH-CO-NH-SO₂-), N-aminosulfonylamide group (-CO-NH-SO₂-NH-) or sulfonylurethane group (-O-CO-NH-SO₂-).

6. The presensitized plate of any one of claims 1 to 5, wherein the polymer comprised in layer (B) is a copolymer of a monomer having at least one group represented by general formula (A) and a monomer comprising at least one alkaline-soluble group.

7. The presensitized plate of claim 6, wherein the monomer comprising at least one group represented by general formula (A) is selected from the group consisting of monomers represented by general formula (B), (C) or (D); 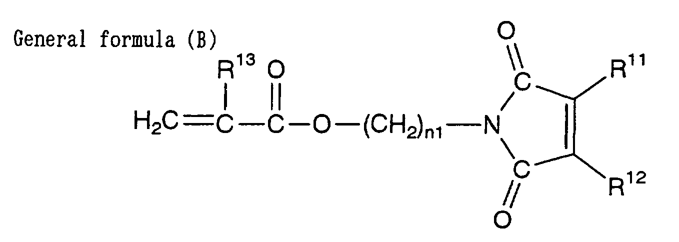 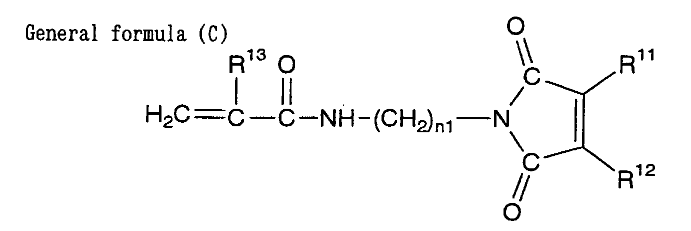 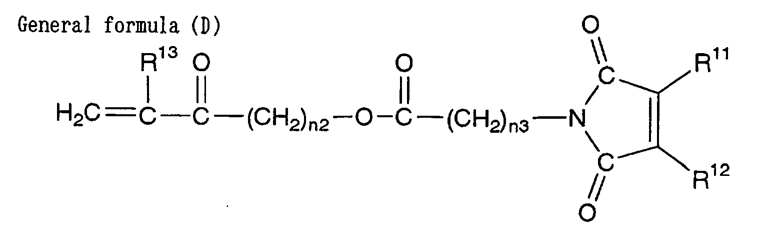 wherein, the definitions of R¹ and R¹² are the same as R and R' of general formula (A) in claim 1; R¹³ represents hydrogen atom or methyl group; and n1, n2 and n3 each represents from 1 to 10.

8. The presensitized plate of claim 6, wherein the monomer comprising at least one alkaline-soluble group is selected from the group consisting of monomers represented by general formula (E), (F), (G) or (H): 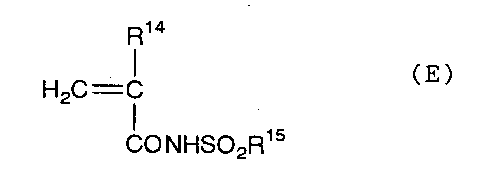 wherein, R¹⁴ represents hydrogen atom or methyl group and R¹⁵ represents hydrocarbon group having 12 or less carbon atoms; 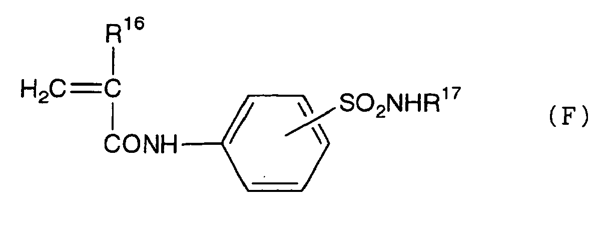 wherein, R¹⁶ represents hydrogen atom or methyl group, R¹⁷ represents hydrogen atom or hydrocarbon group having 12 or less carbon atoms; 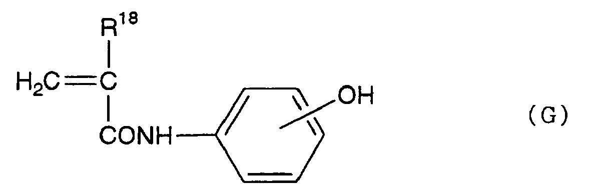 wherein, R¹⁸ represents hydrogen atom or methyl group; 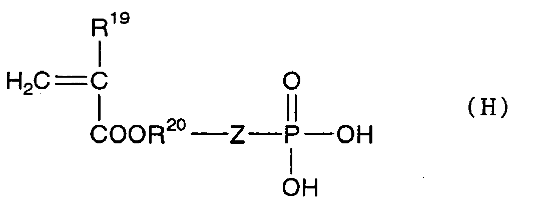 wherein, R¹⁹ represents hydrogen atom or methyl group, R²⁰ represents hydrocarbon connecting group having 12 or less carbon atoms Z represents oxygen atom or single bond.

## Patentansprüche

1. Vorsensibilisierte Platte, die zur Herstellung einer Lithografie-Druckplatte nützlich ist, umfassend eine Schicht (A), die auf ein Aluminiumsubstrat mit einer hydrophilisierten Oberfläche beschichtet ist, und eine Schicht (B), die auf die Schicht (A) beschichtet ist, worin die Schicht (A) zumindest ein Polyurethanharz, das mindestens ein saures Wasserstoffatom aufweist, und zumindest ein Diazoharz umfasst, und die Schicht (B) zumindest einen Sensibilisator und zumindest ein Polymer umfasst, das in alkalischem Wasser löslich oder quellbar ist und das zumindest zwei Gruppen, die durch die folgende allgemeine Formel (A) dargestellt werden, an einer Seitenkette aufweist: 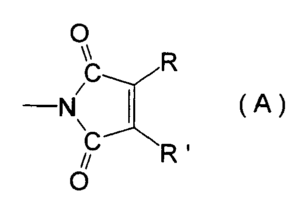 worin R und R' unabhängig voneinander ein Wasserstoffatom, ein Halogenatom oder eine Alkylgruppe darstellen oder R und R' miteinander verbunden sein können, um einen 5- oder 6-gliedrigen Ring zu bilden.

2. Vorsensibilisierte Platte gemäss Anspruch 1, worin das Polyurethan, das mindestens ein saures Wasserstoffatom umfasst, ein ausgewähltes Mitglied der Gruppe ist, die aus Polyurethanharzen besteht, die zumindest eines von -COOH, -SO₂NHCOO-, -CONHSO₂-, -CONHSO₂NH- oder -NHCONHSO₂- aufweisen.

3. Vorsensibilisierte Platte gemäss Anspruch 1 oder 2, worin der Säurewert im Bereich von 0,05 bis 6 mäq je 1 g des Polyurethanharzes liegt.

4. Vorsensibilisierte Platte gemäss irgendeinem der Ansprüche 1 bis 3, worin das Polyurethanharz erhältlich ist durch Umsetzen einer Diisocyanatverbindung, die durch die allgemeine Formel (I) dargestellt wird, mit einer Diolverbindung, die durch die allgemeine Formel (II), (III) oder (IV) dargestellt wird:
OCN-R¹-NCO (I) 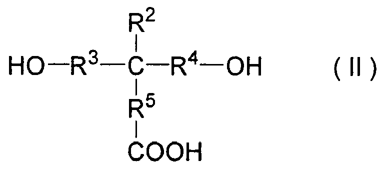 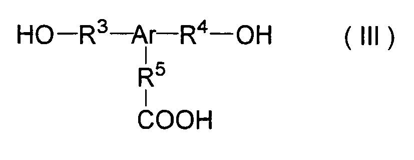 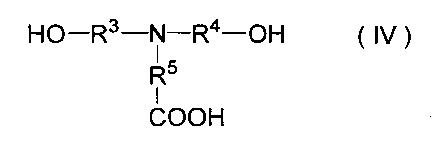
worin R¹ eine bivalente aliphatische oder aromatische Kohlenwasserstoffgruppe darstellt, von denen jede optional mit einer Alkyl-, Alkenyl-, Aralkyl-, Aryl-, Alkoxy- und/oder Halogengruppe substituiert ist; R² ein Wasserstoffatom, eine Alkyl-, Alkenyl-; Aralkyl-, Aryl-, Alkoxy- oder Aryloxygruppe darstellt, von denen jede optional mit einer Alkyl-, Aryl-, Alkoxy-, Ester-, Urethan-, Amid-, Ureido- und/oder Halogengruppe substituiert ist; R³, R⁴ und R⁵ gleich oder verschieden sein können und jedes von ihnen eine Einfachbindung oder eine bivalente aliphatische oder aromatische Kohlenwasserstoffgruppe darstellt, von denen jede optional mit einer Alkyl-, Alkenyl-, Aralkyl-, Aryl-, Alkoxy- und/oder Halogengruppe substituiert ist; und Ar eine trivalente aromatische Kohlenwasserstoffgruppe darstellt, die optional mit einer Alkyl-, Aryl-, Alkoxy-, Ester-, Urethan-, Amid-, Ureido- und/oder Halogengruppe substituiert ist.

5. Vorsensibilisierte Platte gemäss irgendeinem der Ansprüche 1 bis 3, worin das Polyurethanharz erhältlich ist durch Umsetzen einer durch die allgemeine Formel (I) dargestellten Diisocyanatverbindung mit einer durch die allgemeine Formel (V), (VI), (VII) oder (VIII) dargestellten Diolverbindung: 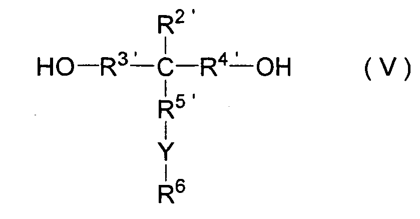 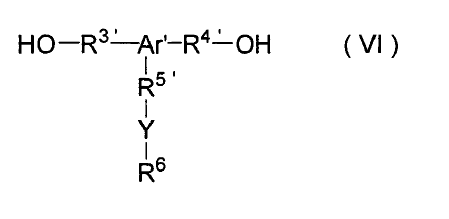 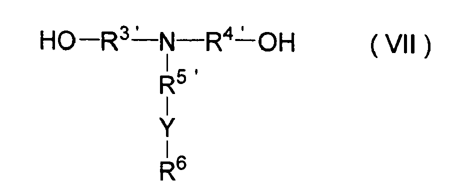
HO-R^{3'}-Y-R^{4'}-OH (VIII)
worin die Definitionen von R^{2'}, R^{3'}, R^{4'}, R^{5'} und Ar' die gleichen sind wie diejenigen von R², R³, R⁴, R⁵ und Ar in Anspruch 4; R⁶ eine monovalente aliphatische oder aromatische Kohlenwasserstoffgruppe darstellt, die optional mit Alkyl, Alkoxy und/oder Halogenatom substituiert ist; und Y eine -Sulfonylamidgruppe (-CO-NH-SO₂-), N-Sulfonylureidogruppe (-NH-CO-NH-SO₂-), N-Aminosulfonylamidgruppe (-CO-NH-SO₂-NH-) oder Sulfonylurethangruppe (-O-CO-NH-SO₂-) darstellt.

6. Vorsensibilisierte Platte gemäss irgendeinem der Ansprüche 1 bis 5, worin das Polymer, das in der Schicht (B) enthalten ist, ein Copolymer aus einem Monomer, das zumindest eine durch die allgemeine Formel (A) dargestellte Gruppe aufweist, und einem Monomer, das zumindest eine alkalilösliche Gruppe aufweist, ist.

7. Vorsensibilisierte Platte gemäss Anspruch 6, worin das Monomer, das zumindest eine durch die allgemeine Formel (A) dargestellte Gruppe umfasst, ausgewählt ist aus der Gruppe bestehend aus Monomeren, die durch die allgemeinen Formeln (B), (C) oder (D) dargestellt werden: 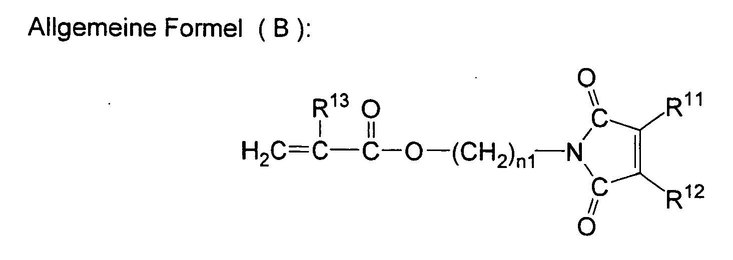 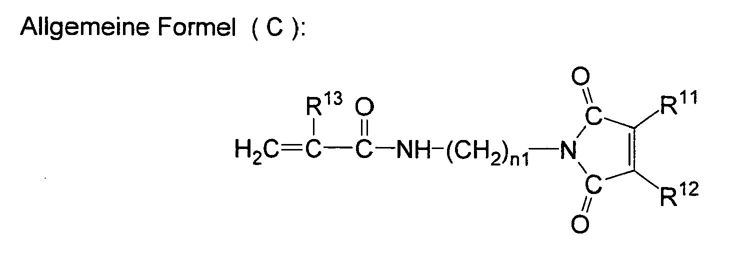 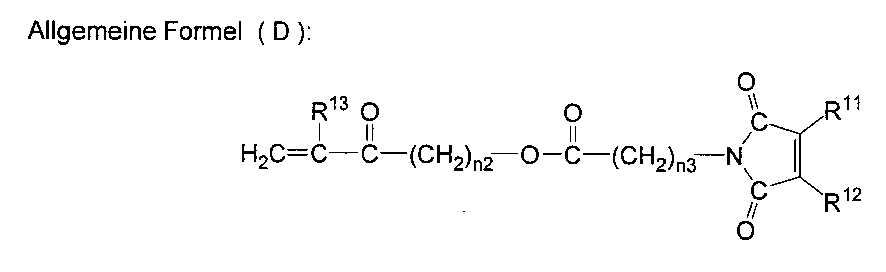 worin die Definitionen von R¹¹ und R¹² die gleichen sind wie von R und R' der allgemeinen Formel (A) in Anspruch 1; R¹³ ein Wasserstoffatom oder eine Methylgruppe darstellt; und n1, n2 und n3 jeweils 1 bis 10 darstellen.

8. Vorsensibilisierte Platte gemäss Anspruch 6, worin das Monomer, das zumindest eine alkalilösliche Gruppe aufweist, ausgewählt ist aus der Gruppe bestehend aus Monomeren, die durch die allgemeinen Formeln (E), (F), (G) oder (H) dargestellt werden: 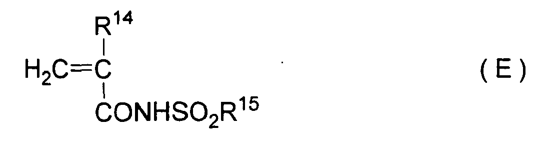 worin R¹⁴ ein Wasserstoffatom oder eine Methylgruppe darstellt und R¹⁵ eine Kohlenwasserstoffgruppe mit 12 oder weniger Kohlenstoffatomen darstellt; 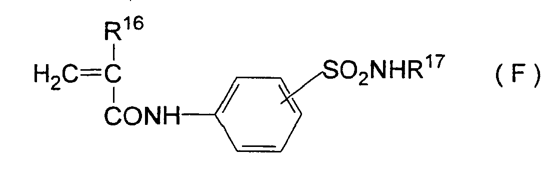 worin R¹⁶ ein Wasserstoffatom oder eine Methylgruppe darstellt und R¹⁷ ein Wasserstoffatom oder eine Kohlenwasserstoffgruppe mit 12 oder weniger Kohlenstoffatomen darstellt; 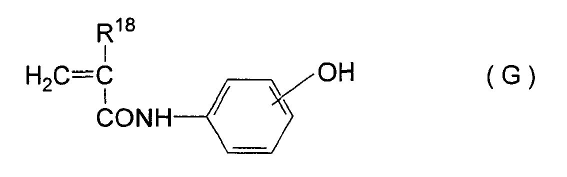 worin R¹⁸ ein Wasserstoffatom oder eine Methylgruppe darstellt; 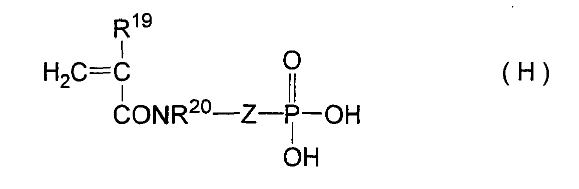 worin R¹⁹ ein Wasserstoffatom oder eine Methylgruppe darstellt, R²⁰ eine verknüpfende Kohlenwasserstoffgruppe mit 12 oder weniger Kohlenstoffatomen darstellt und Z ein Sauerstoffatom oder eine Einfachbindung darstellt.

## Revendications

1. Plaque présensibilisée utile pour préparer une plaque d'impression lithographique comprenant une couche (A) appliquée sur un substrat en aluminium ayant une surface rendue hydrophile et une couche (B) appliquée sur ladite couche (A), où la couche (A) comprend au moins une résine de polyuréthane ayant au moins un atome d'hydrogène acide et au moins une résine diazoïque et la couche (B) comprend au moins un sensibilisateur et au moins un polymère qui est soluble ou gonflable dans une eau alcaline et qui a au moins deux groupes représentés par la formule générale (A) suivante sur la chaîne latérale 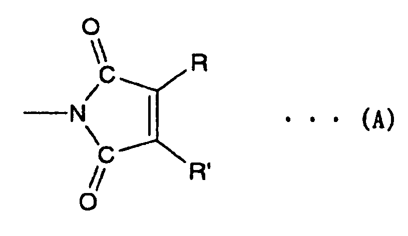 où R et R' représentent indépendamment un atome d'hydrogène, un atome d'halogène ou un groupe alkyle, ou R et R' peuvent être liés l'un à l'autre pour former un cycle à 5 ou 6 chaînons.

2. Plaque présensibilisée selon la revendication 1 où le polyuréthane comprenant au moins un atome d'hydrogène acide est un membre choisi dans le groupe consistant en les résines de polyuréthane ayant au moins un -COOH, -SO₂NHCOO-, -CONHSO₂-, -CONHSO₂NH- ou -NHCONHSO₂-.

3. Plaque présensibilisée selon la revendication 1 ou 2 où l'indice d'acide va de 0,05 à 6 milliéquivalents par gramme de résine de polyuréthane.

4. Plaque présensibilisée selon l'une quelconque des revendications 1 à 3 où la résine de polyuréthane peut être obtenue par réaction d'un composé diisocyanate représenté par la formule générale (I) avec un composé diol représenté par la formule générale (II), (III) ou (IV) ;
OCN-R¹-NCO (I) 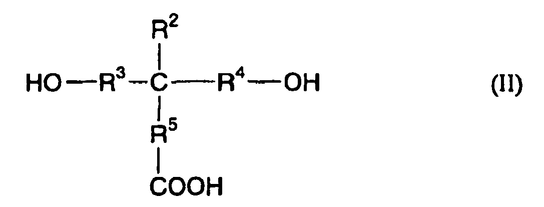 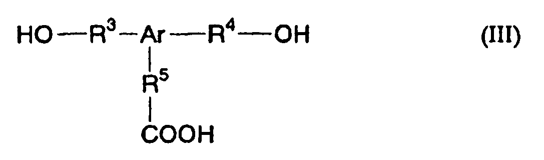 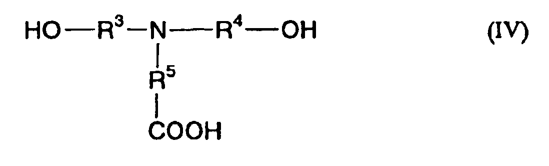
où R¹ représente un hydrocarbure aliphatique ou aromatique divalent éventuellement substitué chacun par un groupe alkyle, alcényle, aralkyle, aryle, alcoxy et/ou halogène ; R² représente un atome d'hydrogène, un groupe alkyle, alcényle, aralkyle, aryle, alcoxy ou aryloxy éventuellement substitué chacun par un groupe alkyle, aryle, alcoxy, ester, uréthane, amide, uréido et/ou halogène ; R³, R⁴ et R⁵ peuvent être identiques ou différents et représentent chacun une simple liaison, un hydrocarbure aliphatique ou aromatique divalent éventuellement substitué chacun par alkyle, alcényle, aralkyle, aryle, alcoxy et/ou halogène ; et Ar représente un hydrocarbure aromatique trivalent qui est éventuellement substitué par un groupe alkyle, aryle, alcoxy, ester, uréthane, amide, uréido et/ou halogène.

5. Plaque présensibilisée selon l'une quelconque des revendications 1 à 3 où la résine de polyuréthane peut être obtenue par réaction d'un composé diisocyanate représenté par la formule générale (I) avec un composé diol représenté par la formule générale (V), (VI), (VII) ou (VIII) ; 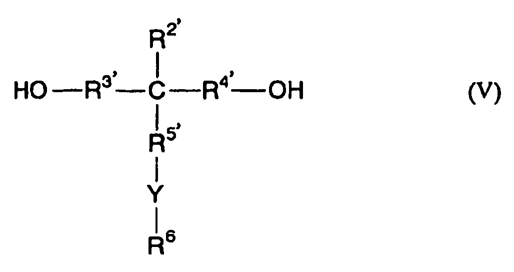 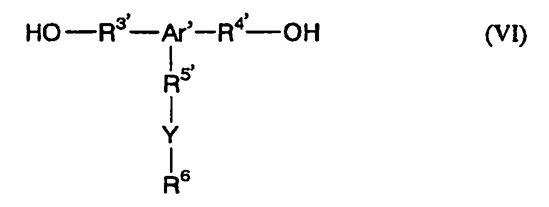 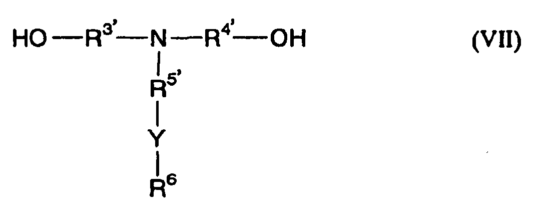
HO-R^{3'}-Y-R^{4'}-OH (VIII)
où les définitions de R^{2'}, R^{3'}, R^{4'}, R^{5'} et Ar' sont les mêmes que celles de R², R³, R⁴, R⁵ et Ar comme dans la revendication 4 ; R⁶ représente un hydrocarbure aliphatique ou aromatique monovalent qui est éventuellement substitué par alkyle, alcoxy et/ou un atome d'halogène ; et Y représente un groupe sulfonylamide (-CO-NH-SO₂-), ou groupe N-sulfonyluréido (-NH-CO-NH-SO₂-), un groupe N-aminosulfonylamide (-CO-NH-SO₂-NH-) ou un groupe sulfonyluréthane (-O-CO-NH-SO₂-).

6. Plaque présensibilisée selon l'une quelconque des revendications 1 à 5 où le polymère compris dans la couche (B) est un copolymère d'un monomère ayant au moins un groupe représenté par la formule générale (A) et d'un monomère comprenant au moins un groupe soluble en milieu alcalin.

7. Plaque présensibilisée selon la revendication 6 où le monomère comprenant au moins un groupe représenté par la formule générale (A) est choisi dans le groupe consistant en les monomères représentés par la formule générale (B), (C) ou (D) ; 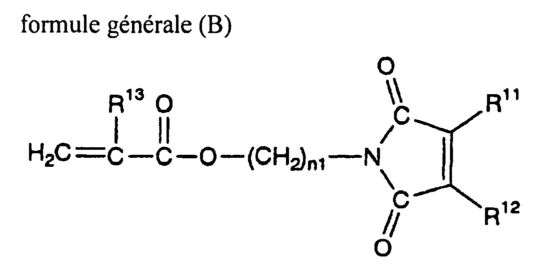 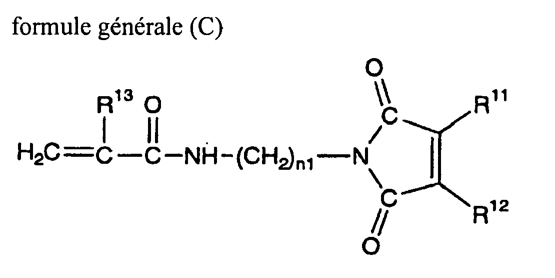 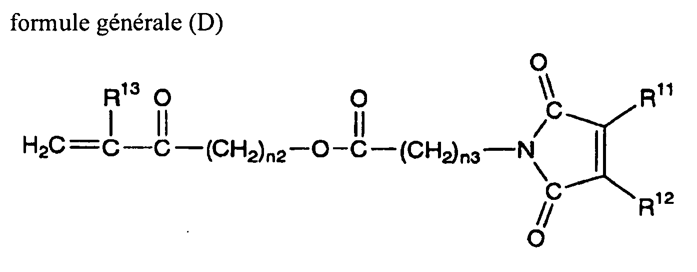 où les définitions de R¹¹ et R¹² sont les mêmes que R et R' de la formule générale (A) dans la revendication 1 ; R¹³ représente un atome d'hydrogène ou un groupe méthyle ; et n1, n2 et n3 représentent chacun de 1 à 10.

8. Plaque présensibilisée selon la revendication 6 où le monomère comprenant au moins un groupe soluble en milieu alcalin est choisi dans le groupe consistant en les monomères représentés par la formule générale (E), (F), (G) ou (H) : 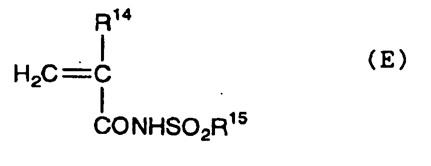 où R¹⁴ représente un atome d'hydrogène ou un groupe méthyle et R¹⁵ représente un groupe hydrocarboné ayant 12 atomes de carbone ou moins ; 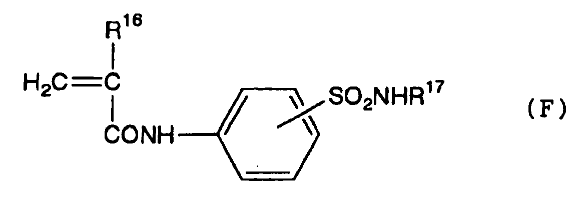 où R¹⁶ représente un atome d'hydrogène ou un groupe méthyle, R¹⁷ représente un atome d'hydrogène ou un groupe hydrocarboné ayant 12 atomes de carbone ou moins ; 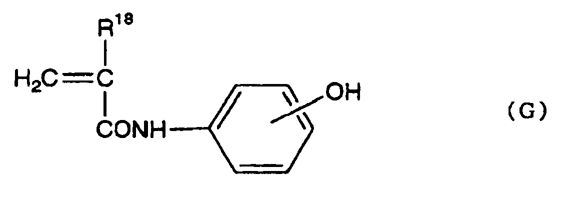 où R¹⁸ représente un atome d'hydrogène ou un groupe méthyle ; 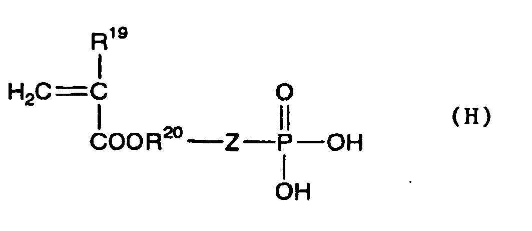 où R¹⁹ représente un atome d'hydrogène ou un groupe méthyle, R²⁰ représente un groupe de liaison hydrocarboné ayant 12 atomes de carbone ou moins, Z représente un atome d'oxygène ou une simple liaison.
